(19) Europäisches Patentamt
European Patent Office
Office européen des brevets

(11) Veröffentlichungsnummer: **0 132 221**
**B1**

(12) # EUROPÄISCHE PATENTSCHRIFT

(45) Veröffentlichungstag der Patentschrift: **18.10.89**

(51) Int. Cl.⁴: **C 08 G 73/10**, G 03 F 7/10

(21) Anmeldenummer: **84810235.6**

(22) Anmeldetag: **14.05.84**

(54) **Polyimide, Verfahren zu deren Herstellung und deren Verwendung.**

**Teilanmeldung 88119435.1 eingereicht am 14/05/85.**

(30) Priorität: **18.05.83 CH 2690/83**
**12.10.83 CH 5571/83**

(43) Veröffentlichungstag der Anmeldung:
**23.01.85 Patentblatt 85/4**

(45) Bekanntmachung des Hinweises auf die Patenterteilung:
**18.10.89 Patentblatt 89/42**

(84) Benannte Vertragsstaaten:
**BE CH DE FR GB IT LI NL SE**

(56) Entgegenhaltungen:
**DE-A- 3 007 445**

**J.W. VAN KREVELEN "Properties of Polymers" 1976, Elsefier scientific publishing company, S.99-104; ELIAS/VOHWINKEL, Neue polymere Werkstoffe für die industrielle Anwendung, 1983, S.257-261; VOLLMERT, Grundriss der makromol. Chemie, Bd.IV, 1982, S.196-203**

(73) Patentinhaber: **CIBA-GEIGY AG, Klybeckstrasse 141, CH-4002 Basel (CH)**

(72) Erfinder: **Pfeifer, Josef, Dr., Brunnmattstrasse 32, CH-4106 Therwil (CH)**

**EP 0 132 221 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft Homo- und Copolyimide aus aromatischen Tetracarbonsäuren und Diaminen, wobei mindestens 5 Mol-% der Tetracarbonsäurereste sich von Benzophenontetracarbonsäure ableiten und mindestens 5 Mol-% der Diamine aromatische Diamine sind, die in beiden Orthostellungen zu mindestens einem N-Atom durch Alkyl, Cycloalkyl, Alkoxy, Alkoxyalkyl oder Aralkyl substituiert sind, ein Verfahren zu deren Herstellung und deren Verwendung zur Herstellung von Schutzfilmen oder photographischen Reliefabbildungen.

Polyimide sind Kunststoffe mit wertvollen thermomechanischen Eigenschaften. Auf Grund ihrer hohen Schmelzbereiche können sie jedoch nicht mit den für Thermoplaste üblichen Formgebungsverfahren verarbeitet werden. Es sind daher lösliche Polyimide entwickelt worden, die als Lacke zur Bildung von Überzugsschichten mit hoher Wärmebeständigkeit verwendet werden können, vgl. DE-AS 1 962 588 und US-PS 3 787 367. Mit der Entwicklung der Elektronik und Halbleitertechnologie werden an Polyimide z.B. als Isolier- und Schutzfilme besonders hohe Anforderungen an deren Thermostabilität gestellt, welche die bekannten Polyimide nicht immer zu erfüllen vermögen.

Es wurde nun gefunden, daß man lösliche Polyimide mit erhöhter Thermostabilität erhält, wenn man mindestens ein aromatisches Diamin verwendet, das in beiden Orthostellungen zu mindestens einer $NH_2$-Gruppe substituiert ist. Es wurde ferner gefunden, daß solche Polyimide unter Strahlungseinwirkung autophotovernetzbar sind, wenn sie mindestens 5 Mol-% Benzophenontetracarbonsäurereste enthalten.

Gegenstand der Erfindung sind Homo- und Copolyimide aus mindestens einer aromatischen Tetracarbonsäure und mindestens einem aromatischen Diamin, die aus 5 bis 100 Mol-% mindestens eines Strukturelementes der Formel I

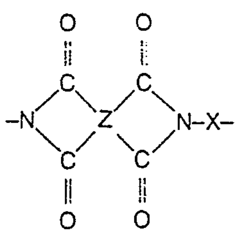

(I)

und 95–0 Mol-% mindestens eines Strukturelementes der Formel II

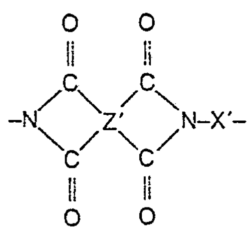

(II),

bestehen, worin

Z einen unsubstituierten oder substituierten vierwertigen aromatischen Rest darstellt, an den je zwei Carbonylgruppen in Ortho- oder Peristellung gebunden sind,

X den zweiwertigen Rest eines aromatischen Diamines bedeutet,

Z′ die gleiche Bedeutung wie Z hat, oder ein von Z verschiedener vierwertiger aromatischer Rest ist und X′ der zweiwertige, von X verschiedene Rest eines organischen Diamines ist, die dadurch gekennzeichnet sind, daß der aromatische Rest von X in beiden Orthostellungen zu mindestens einem N-Atom durch Alkyl, Cycloalkyl, Alkoxy, Alkoxyalkyl oder Aralkyl substituiert ist oder daß zwei benachbarte C-Atome des aromatischen Restes durch Alkylen verbunden sind, mit der Maßgabe, daß mindestens 5 Mol-%, bezogen auf die Tetracarbonsäurereste, an Benzophenontetracarbonsäureresten im Polyimid zugegen sind. Die Strukturelemente der Formel I sind bevorzugt in einer Menge von 20–100 Mol-%, besonders 50–100 Mol-% und insbesondere 80–100 Mol-% und die Strukturelemente der Formel II bevorzugt in einer Menge von 80 bis 0 Mol-%, besonders 50 bis 0 Mol-% und insbesondere 20 bis 0 Mol-% enthalten.

Als aromatischer Rest stellt X bevorzugt einen zweiwertigen, ein- oder zweikernigen Phenylrest dar. Die Substituenten von X können als lineares oder verzweigtes Alkyl und Alkoxy bevorzugt 1 bis 6 und besonders 1 bis 4 C-Atome, als lineares oder verzweigtes Alkoxyalkyl besonders 2 bis 6 C-Atome, und als Cycloalkyl besonders 5 oder 6 Ringkohlenstoffatome enthalten. Das Alkoxyalkyl ist bevorzugt Alkoxymethyl und das Aralkyl Benzyl.

Beispiele für Substituenten sind: Methyl, Äthyl, Propyl, Isopropyl, n-Butyl, Isobutyl, Tertiärbutyl, Pentyl, Hexyl, Octyl, Dodecyl, Tetradecyl, Eicosyl, Cyclopentyl, Cyclohexyl, Methylcyclohexyl, Methoxy, Äthoxy, Propoxy, Butoxy, Pentoxy, Hexoxy, Methoxymethyl, Methoxyäthyl, Äthoxymethyl, Propoxymethyl, Butoxymethyl, Benzyl, Methylbenzyl und Phenyläthyl. Bevorzugte Reste sind Methoxymethyl, Äthoxymethyl, Methyl, Äthyl, Isopropyl, Trimethylen und Tetramethylen. Besonders bevorzugt ist Isopropyl, Äthyl und insbesondere Methyl.

X kann als substituierter aromatischer Rest 8 bis 30, besonders 8 bis 25 C-Atome enthalten. Der aromatische Rest ist bevorzugt ein Pyridinrest und besonders ein Kohlenwasserstoffrest, der durch Alkyl, Alkoxyalkyl, Alkoxy, Trimethylen oder Tetramethylen substituiert ist. Der aromatische Rest kann weitere Substituenten enthalten, z.B. Halogenid wie Cl oder Br. In einer bevorzugten Untergruppe sind die aromatischen Reste als einkernige Reste Phenylenreste und als zweikernige Reste Naphthylen oder Bisphenylenreste.

Eine bevorzugte Untergruppe von erfindungsgemäßen Polyimiden sind solche, in denen X als aromatischer Rest den Formeln III, IIIa und/oder IIIb entspricht,

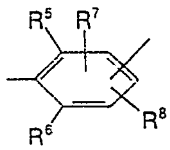
(III)
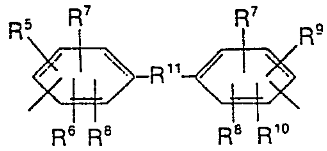
(IIIa)
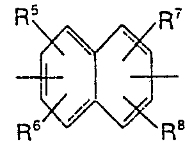
(IIIb)

worin in Formel III die freien Bindungen in Meta- oder Parastellung zueinander stehen, in Formel IIIa die freien Bindungen bevorzugt in Meta- oder Parastellung zur $R^{11}$-Gruppe stehen und $R^5$ und $R^6$ in den beiden Orthostellungen der freien Bindung gebunden sind, und in Formel IIIb die freien Bindungen in 2-, 3-, 6- und 7-Stellung gebunden sind und $R^5$ und $R^6$ sich in den beiden Orthostellungen der freien Bindungen befinden, $R^{11}$ für eine direkte Bindung, –O–, –S–, –SS–, –SO–, $-SO_2-$, –CO–, –COO–, –NH–, –N-Alkyl mit 1 bis 6 C-Atomen im Alkyl, –N-Phenyl, –N-Benzyl, –CONH–, –CON-Alkyl- mit 1 bis 6 C-Atomen im Alkyl, –CON-Phenyl-, –CON-Benzyl-,

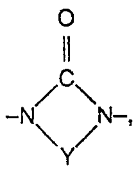, worin Y für 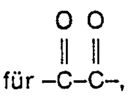, 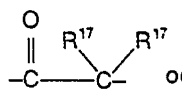 oder 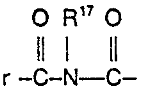 steht und

$R^{17}$ ein Wasserstoffatom, $C_1$–$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy, oder die Gruppe 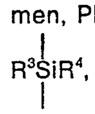,

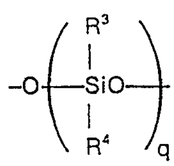 oder $-(R)_t-(Q)_s$ 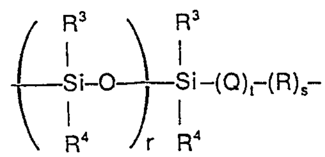 steht, worin $R^3$ und $R^4$ Alkyl oder Alkoxy mit 1 bis 6 C-Atomen, Phenyl, Benzyl, Phenyloxy oder Benzyloxy sind, r eine Zahl von 1 bis 10, t 0 oder 1 und S 0 oder 1 ist, und R –O– oder –S– und Q $C_1$–$C_6$-Alkylen bedeuten, und q für eine Zahl von 1 bis 100 steht, $R^5$ und $R^6$ Alkyl, oder Alkoxy mit 1 bis 12 C-Atomen, Alkoxyalkyl mit 2 bis 12 C-Atomen Cyclopentyl, Cyclohexyl oder Benzyl sind oder in den Formeln III oder IIIa $R^5$ und $R^7$ in Nachbarstellung gebunden sind und zusammen Trimethylen oder Tetramethylen bedeuten, wobei $R^6$ auch ein Wasserstoffatom sein kann, $R^7$ und $R^8$ ein Wasserstoffatom sind oder unabhängig die Bedeutung von $R^5$ und $R^6$ haben, und $R^9$ und $R^{10}$ ein Wasserstoffatom sind, unabhängig die Bedeutung von $R^5$ und $R^6$ haben oder $R^7$ und $R^9$ in Formel IIIa zusammen Trimethylen oder Tetramethylen sind. $R^5$ und $R^6$ sind bevorzugt Alkyl mit 1 bis 6 C-Atomen, besonders Methyl, Äthyl, n-Propyl und Isopropyl. Die freien Bindungen der Formel IIIa befinden sich bevorzugt in Meta- und besonders Parastellung zur $R^{11}$-Gruppe. Das Alkyl in den $R^{11}$-Resten kann z.B. Methyl, Äthyl, Propyl, Isopropyl, n-Butyl oder Pentyl sein. $R^{11}$ als Alkylen ist bevorzugt Äthylen und besonders Methylen. Als Alkyliden enthält $R^{11}$ bevorzugt 2 bis 6 C-Atome. Beispiele sind Äthyliden, 2,2-Butyliden, 2,2- oder 3,3-Pentyliden, Hexafluorpropyliden und besonders 2,2-Propyliden. $R^{11}$ als Cycloalkyliden kann z.B. als Cyclopentyliden und besonders Cyclohexyliden sein. Die $R^{11}$-Gruppe ist bevorzugt eine direkte Bindung, –O–, –S–, $SO_2$–, –CO–, Alkylen und Alkyliden. Besonders bevorzugt ist $R^{11}$ eine direkte Bindung, –O–, und insbesondere –CO– oder $-CH_2-$. $R^3$ und $R^4$ sind bevorzugt Alkyl, besonders Methyl oder Phenyl. R steht bevorzugt für –O– und Q bevorzugt für Methylen oder Äthylen, q ist bevorzugt eine Zahl von 1 bis 10 und r eine Zahl von 1–20, besonders 1–10.

Eine weitere Gruppe von Diaminresten sind solche der Formel

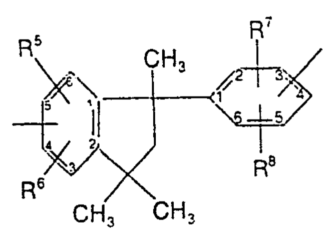

worin die freie Bindung in 4'- oder 5'-Stellung gebunden ist und die andere in 3-, 5-, und bevorzugt 4-Stellung, $R^5$ und $R^6$ und/oder $R^7$ und $R^8$ sich in den Orthostellungen der freien Bindung befinden und für Alkyl oder Alkoxy mit 1 bis 12 C-Atomen oder Alkoxyalkyl mit 2 bis 12 C-Artomen stehen.

Eine besonders bevorzugte Untergruppe von erfindungsgemäßen Polyimiden sind jene, in denen X in Formel I Resten der Formeln

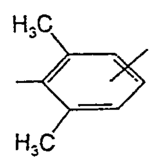,
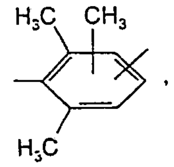,
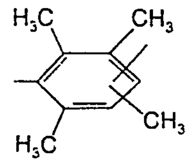,
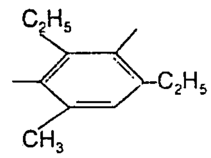

entsprechen, worin die freien Bindungen in Meta- oder Parastellung zueinander stehen, oder der Formel

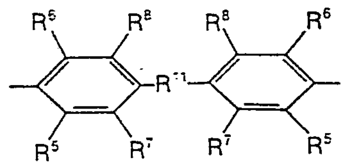

entsprechen, worin $R^5$ und $R^6$ unabhängig Methyl, Äthyl, n-Propyl oder Isopropyl und $R^7$ und $R^8$ ein Wasserstoffatom sind oder die Bedeutung von $R^5$ haben oder $R^5$ und $R^7$ zusammen Tri- oder Tetramethylen bedeuten und $R^6$ und $R^8$ ein Wasserstoffatom sind, und $R^{11}$ eine direkte Bindung, $CH_2$, 2,2-Propyliden oder CO ist. Unter diesen zweikernigen Resten sind besonders solche bevorzugt, in denen $R^5$, $R^6$, $R^7$ und $R^8$ für Methyl stehen. Copolyimide, die mindestens 2 verschiedene Reste dieser Formeln enthalten, sind eine weitere bevorzugte Ausführungsform der Erfindung.

Erfindungsgemäße Copolyimide enthalten mindestens zwei verschiedene Strukturelemente, wobei sich die Anzahl an verschiedenen Strukturelementen im wesentlichen nach den gewünschten Eigenschaften und dem Anwendungsgebiet richten. Bevorzugt enthalten sie 2 bis 4 verschiedene Strukturelemente, wobei sich die Strukturelemente nur im Rest X der Formel I unterscheiden können. In einer besonders bevorzugten Ausführungsform solcher Copolyimide sind Strukturelemente von Ortho-disubstituierten Phenylenen enthalten, besonders von 1,3-Phenylenen.

Beispiele für X sind:
2,6-Dimethyl-1,4- oder 1,3-phenylen,
2,6-Diäthyl-1,4- oder 1,3-phenylen,
2,6-Dimethyl-5-chlor-1,4- oder 1,3-phenylen,
2-Methyl-6-äthyl-1,4- oder 1,3-phenylen,
2-Methyl-6-isopropyl-1,4- oder 1,3-phenylen,
2,6-Diisopropyl-1,4- oder 1,3-phenylen,
2,6-Dimethoxy-1,4- oder 1,3-phenylen,
2,6-Diäthoxy-1,4- oder 1,3-phenylen,
2-Methyl-6-methoxy-1,4- oder 1,3-phenylen,
2,6-Dibenzyl-1,4- oder 1,3-phenylen,
2,6-Dimethoxymethyl-1,4- oder 1,3-phenylen,
2,5,6-Trimethyl-1,4- oder 1,3-phenylen,
2,5,6-Triäthyl-1,4- oder 1,3-phenylen,
2,4,6-Trimethyl-1,3-phenylen,
2,3,5,6-Tetramethyl-1,4-phenylen,
2,4,5,6-Tetramethyl-1,3-phenylen,
Tetrahydro-1,4- oder 1,3-naphthylen,
Reste der Formeln

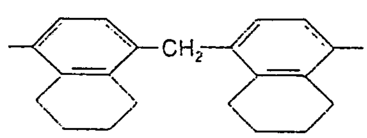,
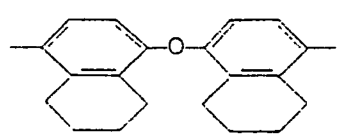,

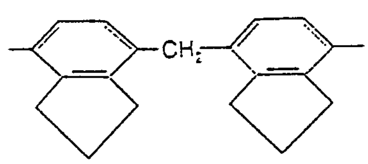,
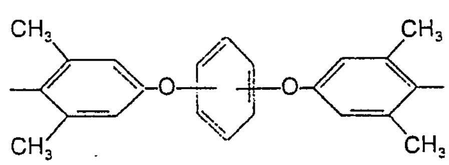

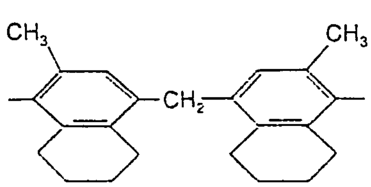,
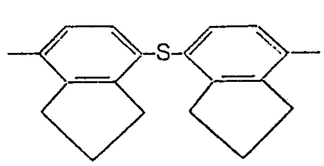,

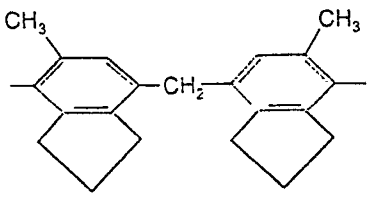

,

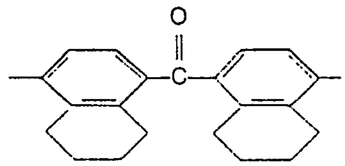

,

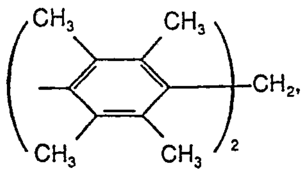

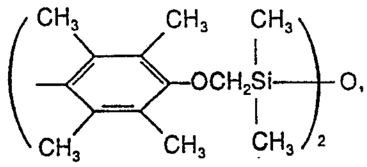

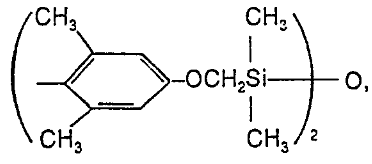

sowie

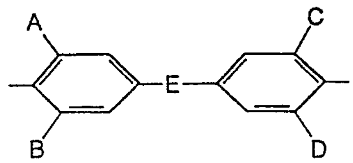

,

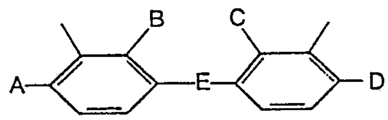

und

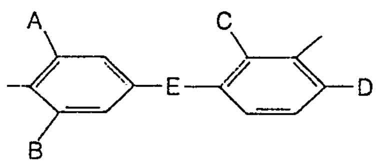

worin A, B, C, D und E die in nachfolgender Tabelle angegebenen Bedeutungen haben. Die freien Positionen in den Phenylkernen können hierbei durch einen oder zwei weitere Substituenten in jedem Kern besetzt sein, wobei diese Substituenten die in nachfolgender Tabelle für A, B, C oder D angegebene Bedeutung haben können:

| E | A | B | C | D |
|---|---|---|---|---|
| $CH_2$ | Methyl | Methyl | H | H |
| $CH_2$ | Methyl | Äthyl | H | H |
| $CH_2$ | Äthyl | Äthyl | H | H |
| $CH_2$ | Isopropyl | Isopropyl | H | H |
| $CH_2$ | Methoxymethyl | | H | H |
| $CH_2$ | Benzyl | Benzyl | H | H |
| $CH_2$ | Methyl | Methyl | Methyl | H |
| $CH_2$ | Äthyl | Äthyl | Äthyl | H |
| $CH_2$ | Isopropyl | Isopropyl | Methyl | Methyl |
| $CH_2$ | Methoxymethyl | | Methyl | H |
| $CH_2$ | Methyl | Äthyl | Methyl | H |
| $CH_2$ | Methoxymethyl | | Methoxymethyl | |
| $CH_2$ | Methyl | Methyl | Methyl | Methyl |
| $CH_2$ | Äthyl | Äthyl | Äthyl | Äthyl |
| $CH_2$ | Methyl | Methyl | Äthyl | Äthyl |
| $CH_2$ | Äthyl | Äthyl | Isopropyl | Isopropyl |
| $CH_2$ | Isopropyl | Isopropyl | Isopropyl | Isopropyl |
| $CH_2$ | Isopropyl | Isopropyl | Methyl | H |
| $CH_2$ | Methoxy | Methoxy | Methyl | Methyl |
| O | Methyl | Methyl | H | H |
| O | Äthyl | Äthyl | H | H |
| O | Methyl | Methyl | Methyl | H |
| O | Methyl | Methyl | Methyl | Methyl |
| O | Methyl | Methyl | Äthyl | Äthyl |
| S | Methyl | Methyl | H | H |

| E | A | B | C | D |
|---|---|---|---|---|
| S | Äthyl | Äthyl | H | H |
| S | Methyl | Methyl | H | H |
| S | Methyl | Methyl | Methyl | Methyl |
| S | Äthyl | Äthyl | Äthyl | Äthyl |
| S | Methyl | Methyl | Äthyl | Äthyl |
| CO | Methyl | Methyl | Methyl | H |
| CO | Methyl | Methyl | H | H |
| CO | Methyl | Methyl | Methyl | Methyl |
| $SO_2$ | Methyl | Methyl | Äthyl | H |
| $SO_2$ | Methyl | Methyl | H | H |
| $SO_2$ | Methyl | Methyl | Methyl | Methyl |
| $SO_2$ | Äthyl | Äthyl | Methyl | Methyl |
| SO | Methyl | Methyl | Methyl | Methyl |
| SO | Methyl | Methyl | H | H |
| COO | Methyl | Methyl | H | H |
| COO | Methyl | Methyl | Methyl | Methyl |
| $CONCH_3$ | Methyl | Methyl | H | H |
| $NCH_3$ | Methyl | Methyl | Äthyl | Äthyl |
| $NCH_3$ | Methyl | Methyl | Methyl | Methyl |
| CONH | Methyl | Methyl | – | – |
| NH | Äthyl | Methyl | Äthyl | Methyl |
| NH | Methyl | Methyl | Methyl | Methyl |
| $Si(Methyl)_2$ | Methyl | Methyl | H | H |
| $Si(Phenyl)_2$ | Methyl | Methyl | Methyl | Methyl |
| $Si(OMethyl)_2$ | Äthyl | Äthyl | H | H |
| $Si(OPhenyl)_2$ | Methyl | Methyl | Methyl | Methyl |
| $-OSi(Methyl)_2O-$ | Methyl | Methyl | Methyl | Methyl |
| Äthylen | Methyl | Methyl | H | H |
| Äthylen | Methyl | Methyl | Methyl | Methyl |
| Äthylen | Äthyl | Äthyl | H | H |
| Äthylen | Methyl | Methyl | Äthyl | Äthyl |
| Phenylen | Methyl | Methyl | Methyl | Methyl |
| Phenylen | Äthyl | Äthyl | H | H |
| $(CH_3)_2C<$ | Methyl | Äthyl | Methyl | Äthyl |
| $(CH_3)_2C<$ | Methyl | Methyl | Methyl | Methyl |
| $(CF_3)_2C<$ | Methyl | Methyl | Methyl | Methyl |
| direkte Bindung | Methyl | Methyl | H | H |
| direkte Bindung | Methyl | Äthyl | Methyl | Äthyl |
| direkte Bindung | Methyl | Äthyl | Methyl | H |
| direkte Bindung | Äthyl | Äthyl | Äthyl | Äthyl |
| direkte Bindung | Methoxy | Methoxy | Methoxy | Methoxy |
| direkte Bindung | Isopropyl | Isopropyl | H | H |
| direkte Bindung | Methoxymethyl | Methoxymethyl | Methoxymethyl | Methoxymethyl |

Die Diamine, von denen sich X ableitet, sind bekannt oder nach bekannten Verfahren herstellbar. Si-haltige Diamine sind in der US-PS 3 435 002 und der EP-A-0 054 426 beschrieben. Diamine mit der

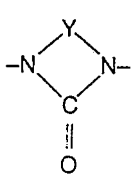
Gruppe

können aus den in der DE-A-2 318 170 beschriebenen Diisocyanaten hergestellt werden. Alkyl- oder Cycloalkyl substituierte, besonders Äthyl oder Propyl substituierte Diamine sind durch Alkylierungen von unsubstituierten oder teilsubstituierten aromatischen Diaminen mit Alkenen bzw. Cycloalkenen zugänglich (vgl. US-PS-3 275 690). Mehrkernige, besonders zweikernige aromatische Diamine sind über die Kondensation entsprechender Monoamine mit Aldehyden oder Ketonen erhältlich.

X′ im Strukturelement der Formel II kann lineares oder verzweigtes Alkylen mit 2 bis 30 C-Atomen, Cycloalkylen mit 5 bis 8 Ringkohlenstoffatomen, Aralkylen mit 7 bis 30 C-Atomen, Arylen mit 6 bis 22 C-Atomen und/oder ein Polysiloxanrest sein.

X′ in Formel II in der Bedeutung als zweiwertiger aliphatischer Rest enthält bevorzugt 6 bis 30 und insbesondere 6 bis 20 C-Atome. In einer bevorzugten Untergruppe ist X′ lineares oder verzweigtes Alkylen, das durch Sauerstoffatome, NH,

$NR^a$, $^{\oplus}NR^a_2\ G^{\ominus}$, Cyclohexylen, Naphthylen, Phenylen oder Hydantoinreste unterbrochen sein kann. $R^a$ kann z.B. Alkyl mit 1 bis 12 C-Atomen oder Cycloalkyl mit 5 oder 6 Ring-C-Atomen, Phenyl oder Benzyl sein. $G^{\ominus}$ bedeutet ein Anion einer Protonensäure, z.B. Halogenid, Sulfat, Phosphat. In einer bevorzugten Ausführungsform sind R bzw. R′ lineares oder verzweigtes Alkylen mit 6 bis 30 C-Atomen, $-(CH_2)_m-R^{13}-(CH_2)_n-$, worin $R^{13}$ Phenylen, Naphthylen, Cyclopentylen oder Cyclohexylen und m und n unabhängig voneinander die Zahl 1, 2 oder 3 sind, $-R^{14}-(-OR^{15}-)_p-O-R^{14}-$, worin $R^{14}$ Äthylen, 1,2-Propylen, 1,3-Propylen oder 2-Methyl-1,3-propylen und $R^{15}$ Äthylen, 1,2-Propylen, 1,2-Butylen, 1,3-Propylen oder 1,4-Butylen und p eine Zahl von 1 bis 100 sind, oder

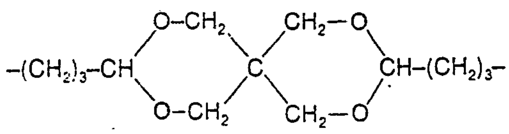

Beispiele für aliphatische Reste sind: Methylen, Äthylen, 1,2- oder 1,3-Propylen, 2,2-Dimethyl-1,3-propylen, 1,2-, 1,3- oder 1,4-Butylen, 1,3- oder 1,5-Pentylen, Hexylene, Heptylene, Octylene, Decylene, Dodecylene, Tetradecylene, Hexadecylene, Octadecylene, Eicosylene, 2,4,4-Trimethylhexylen, 1,10-Dialkyldecylen, wobei das Alkyl bevorzugt 1- bis 6 C-Atome aufweist, substituierte 1,11-Undecylene, wie sie z.B. in der EP-B-0 011 559 beschrieben sind, Reste von Jeffaminen wie z.B.

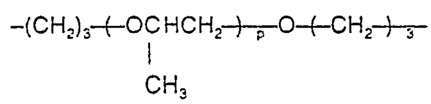

mit p = 1 bis 100 oder

$-(CH_2-)_3-(-O(CH_2)_4-)_p-O-(-CH_2-)_3-$

mit p = 1–100, Dimethylencyclohexan, Xylylen und Diäthylenbenzol.

Bei den durch heterocyclische Reste unterbrochenen aliphatischen Resten kann es sich z.B. um solche handeln, die sich von N,N′-aminoalkylierten Hydantoinen oder Benzimidazolen ableiten. Beispiele sind N,N′-(γ-Aminopropyl)-5,5-dimethylhydantoin oder -benzimidazolon und solche der Formel

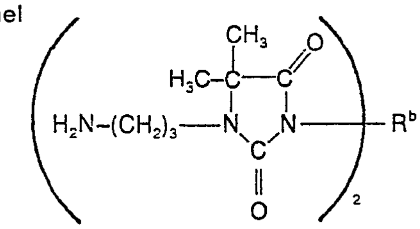

worin $R^b$ Alkylen mit 1 bis 12, bevorzugt 1 bis 4 C-Atomen oder

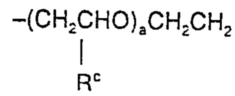

ist, worin $R^c$ ein Wasserstoffatom oder Methyl und a ganze Zahlen von 1–20 bedeuten.

Geeignete Substituenten für die aliphatischen Reste sind z.B. Hydroxyl, Halogenid wie F oder Cl oder Alkoxy mit 1 bis 6 C-Atomen.

X′ in Formel II in seiner Bedeutung als zweiwertiger cycloaliphatischer Rest enthält bevorzugt 5 bis 8 Ring-C-Atome und ist besonders unsubstituiertes, oder mit Alkyl, das vorzugsweise 1 bis 4 C-Atome enthält, substituiertes ein- oder zweikerniges Cycloalkylen mit 5 bis 7 Ring-C-Atomen. In einer bevorzugten Ausführungsform ist X′ als cycloaliphatischer Rest ein solcher der Formeln

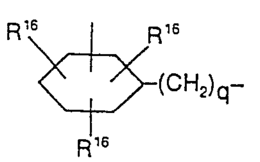

oder

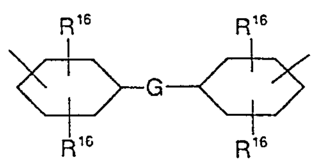

,

worin q 0 oder 1 ist, die $R^{16}$ unabhängig Wasserstoff oder Alkyl mit 1 bis 6 C-Atomen bedeuten und G eine direkte Bindung O, S, $SO_2$, Alkylen mit 1 bis 3 C-Atomen oder Alkyliden mit 2 bis 6 C-Atomen steht. $R^{16}$ ist bevorzugt Äthyl und Methyl, G bevorzugt Methylen und das Alkyliden enthält bevorzugt 2 oder 3 C-Atome, wie Äthyliden und 1,1- oder 2,2-Propyliden.

Beispiele für X′ als Cycloalkylen sind:
1,2- oder 1,3-Cyclopentylen,
1,2-, 1,3- oder 1,4-Cyclohexylen,
Cycloheptylen, Cyclooctylen,
Methylcyclopentylen, Methyl- oder Dimethylcyclohexylen,
3- oder 4-Methylcyclohex-1-yl,
5-Methyl-3-methylencyclohex-1-yl,
3,3′- oder 4,4′-Bis-cyclohexylen,
3,3′-Dimethyl-4,4′-biscyclohexylen,
4,4′-Biscyclohexylenäther oder -sulfon oder -methan oder -2,2-propan,

sowie die Reste von Bis-aminomethyl-tricyclodecan, Bis-aminomethylnorbornan und Menthandiamin.

Besonders bevorzugt ist X′ als cycloaliphatischer Rest
1,4- oder 1,3-Cyclohexylen,
3,5,5-Trimethylcyclohex-1-yl-3-meth-1-yl,
Methylenbis(cyclohex-4-yl) oder
Methylenbis(3-methylcyclohex-4-yl).

X′ als araliphatischer Rest enthält bevorzugt 7 bis 30 C-Atome. Die aromatischen Gruppen sind bevorzugt so substituiert wie X′ als aromatischer Rest, einschließlich der Bevorzugungen, zumindest aber monosubstiuiert, bevorzugt in Orthostellung zum N-Atom. Der araliphatische Rest enthält besonders 8 bis 26 C-Atome. Der aromatische Rest im araliphatischen Rest ist bevorzugt ein Phenylrest. In seiner Bedeutung als araliphatischer Rest ist X′ besonders unsubstituiertes oder am Aryl durch Alkyl substituiertes Aralkylen, wobei der Alkylenrest linear oder verzweigt ist. In einer bevorzugten Ausführungsform entspricht der araliphatische Rest der Formel

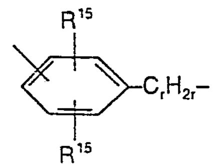

worin die $R^{15}$ unabhängig voneinander ein Wasserstoffatom oder besonders Alkyl mit 1–6 C-Atomen und r ganze Zahlen von 1–20 bedeuten.

Die freie Bindung befindet sich bevorzugt in m-Stellung oder p-Stellung zur $C_rH_{2r}$-Gruppe und eine oder beide $R^{15}$ sind bevorzugt in o-Stellung zur freien Bindung gebunden.

Beispiele für X' als araliphatischer Rest sind:
m- oder p-Benzylen, 3-Methyl-p-benzylen,
3-Äthyl-p-Benzylen, 3,5-Dimethyl-p-benzylen,
3,5-Diäthyl-p-benzylen,
3-Methyl-5-äthyl-p-benzylen,
p-Phenylenpropylen, 3-Methyl-p-phenylenpropylen,
p-Phenylenbutylen,
3-Äthyl-p-phenylenpentylen
sowie insbesondere längerkettige Phenylenalkylenreste, die z.B. in der EP-A-0 069 062 beschrieben sind:
6-(p-Phenylen)-6-methylhept-2-yl,
6-(3'-Methyl-p-phenylen)-6-methylhept-2-yl,
6-(3'-Äthyl-p-phenylen)-6-methylhept-2-yl,
6-(3',5'-Dimethyl-p-phenylen)-6-methylhept-2-yl,
11-(p-Phenylen)-2,11-dimethyl-dodec-1-yl,
13-(p-Phenylen)-2,12-dimethyltetradec-3-yl.

X' als Arylen enthält bevorzugt 6 bis 22 C-Atome. Das Arylen ist besonders ein ein- oder zweikerniger Phenylenrest. Das Arylen kann substituiert sein, z.B. durch Alkyl oder Alkoxy mit 1 bis 6 C-Atomen, Alkoxymethyl mit 2 bis 6 C-Atomen und/oder Halogen wie F oder Cl. Bevorzugt sind substituierte aromatische Reste, da solche Copolyimide im allgemeinen löslicher sind. Ferner sind 1,3-Phenylene bevorzugt, die in der Orthostellung zur freien Bindung durch Alkyl mit 1 bis 4 C-Atomen, besonders Methyl, substituiert sind.

In einer Ausführungsform entspricht X' der Formel IV,

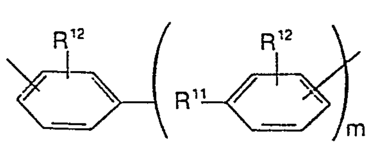 (IV)

worin m 0 oder 1 ist, die freien Bindungen in Meta- und bevorzugt in Orthostellung zur $R^{12}$-Gruppe gebunden sind, $R^{11}$ die gleiche Bedeutung wie in Formel IIIa hat und $R^{12}$ die gleiche Bedeutung wie $R^5$ hat.

Eine bevorzugte Untergruppe sind Arylenreste der Formeln IVa, oder IVb oder IVc

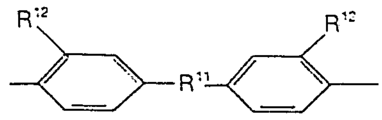 (IVa) ,

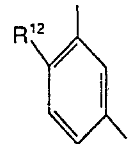 (IVb) , 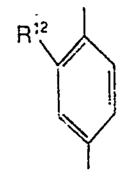 (IVc) .

worin $R^{11}$ für eine direkte Bindung, –O–, –CO– oder $-CH_2-$ steht und $R^{12}$ Methyl, Äthyl, Isopropyl, Methoxy, Äthoxy oder ein Wasserstoffatom bedeutet.

Beispiele für Diamine $H_2N-X'-NH_2$ mit einem aromatischen Rest sind:
4,4'-Methylenbis-(o-chloranilin),
3,3'-Dichlorbenzidin, 3,3'-Sulfonyldianilin,
4,4'-Diaminobenzophenon,
1,5-Diaminonaphthalin,
Bis-(4-aminophenyl)-dimethylsilan,
Bis-(4-aminophenyl)-diäthylsilan,
Bis-(4-aminophenyl)-diphenylsilan,
Bis-(4-aminophenyloxy)-dimethylsilan,
Bis-(4-aminophenyl)-äthylphosphinoxid,
N-[Bis-(4-aminophenyl)]-N-methylamin,
N-[Bis-(4-aminophenyl)]-N-phenylamin,
4,4'-Methylenbis-(3-methylanilin),
4,4'-Methylenbis-(2-äthylanilin),
4,4'-Methylenbis-(2-methoxyanilin),
5,5'-Methylenbis(2-aminophenol),
4,4'-Methylenbis-(2-methylanilin),
4,4'-Oxybis-(2-methoxyanilin),
4,4'-Oxybis-(2-chloranilin),
5,5'-Oxybis-(2-aminophenol),
4,4'-Thiobis-(2-methylanilin),
4,4'-Thiobis-(2-methoxyanilin),
4,4'-Thiobis-(2-chloranilin),
4,4'-Sulfonylbis-(2-methylanilin),
4,4'-Sulfonylbis-(2-äthoxyanilin),
4,4'-Sulfonylbis-(2-chloranilin),
5,5'-Sulfonylbis-(2-aminophenol),
3,3'-Dimethyl-4,4'-diaminobenzophenon,
3,3'-Dimethoxy-4,4'-diaminobenzophenon,
3,3'-Dichlor-4,4'-diaminobenzophenon,
4,4'-Diaminobiphenyl, m-Phenylendiamin,
p-Phenylendiamin, 4,4'-Methylendianilin,
4,4'-Oxydianilin, 4,4'-Thiodianilin,
4,4'-Sulfonyldianilin,
4,4'-Isopropylidendianilin,
3,3'-Dimethylbenzidin,
3,3'-Dimethoxybenzidin,
3,3'-Dicarboxybenzidin, Diaminotoluol,
4,4'-Methylen-bis-(3-carboxyanilin)
und deren Ester,
5-Amino-1-(4-aminophenyl)-1,3,5-Trimethylindan.

X' kann auch ein Siloxangruppen enthaltender zweiwertiger Rest sein. Dieser kann der Formel

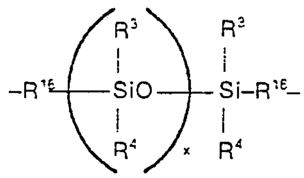

entsprechen, worin X für eine rationale Zahl von mindestens 1 steht, $R^3$ und $R^4$ die zuvor angegebene Bedeutung haben und $R^{16}$ ein zweiwertiger Kohlenwasserstoffrest ist, z.B. Alkylen mit 1 bis 12, vorzugsweise 1 bis 6 C-Atomen, Cycloalkylen mit bevorzugt 5 oder 6 Ringkohlenstoffatomen oder Phenylen. $R^3$ und $R^4$ sind bevorzugt Methyl oder Phenyl und X bevorzugt eine Zahl von 1 bis 1000, besonders 1 bis 100 und insbesondere 1–10. Beispiele für Alkylen sind Äthylen, 1,3- oder 1,2-Propylen, 1,3- oder 1,4-Butylen. Diamine mit dieser Gruppe X′ sind in der US-PS 4 030 948 beschrieben. Weitere geeignete Diamine mit einer Siloxangruppen enthaltenden Gruppe X′ sind in der US-PS 3 435 002 und EP-A-0 054 426 beschrieben.

Es ist bekannt, daß einige aliphatische und aromatische Diamine, z.B. Phenylendiamin oder Di(aminophenyl)methan, die Unlöslichkeit von Polyimiden fördern können. Solche Diamine werden daher bevorzugt in geringeren Mengen eingesetzt. Insbesondere sind für diesen Fall die Strukturelemente der Formel I zu mindestens 50 Mol-%, besonders 80 Mol-% und ganz besonders 90 Mol-% enthalten.

Z und Z′ enthalten als vierwertiger aromatischer Rest bevorzugt 6 bis 30, besonders 6 bis 20 C-Atome. In einer bevorzugten Untergruppe entsprechen Z und Z′ den Formeln

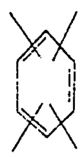, 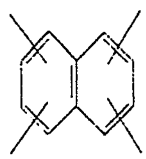,

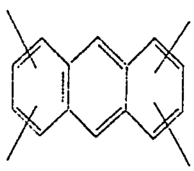, 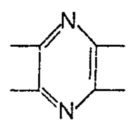, 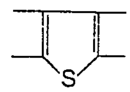

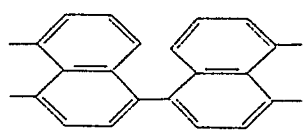, 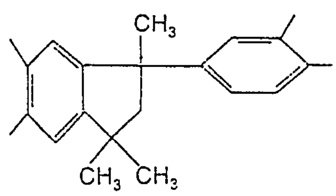

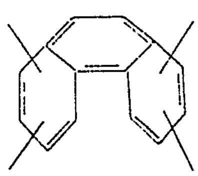, 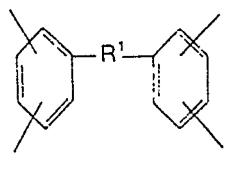

worin $R^1$ eine direkte Bindung oder eine Brückengruppe der Formeln

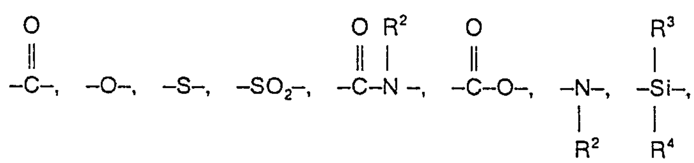

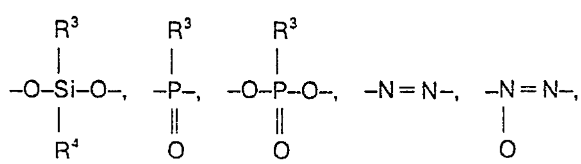

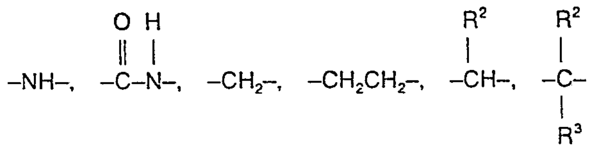

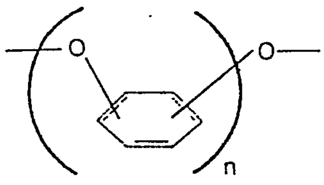

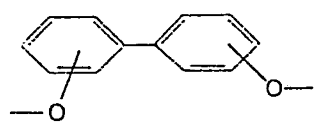

ist, worin $R^2$, $R^3$ und $R^4$ Alkyl mit 1 bis 6 C-Atomen, Phenyl oder Benzyl und $R^3$ und $R^4$ Alkoxy mit 1 bis 6 C-Atomen, Phenyloxy oder Benzyloxy sind.

In den vorausstehenden Formeln befinden sich stets je zwei der freien Bindungen in Peri- und/oder Orthostellung.

Eine bevorzugte Untergruppe für Z und Z' sind Reste der Formeln

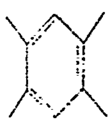

oder

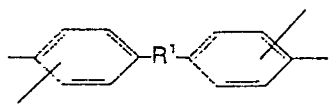

ist, worin $R^1$ eine direkte Bindung, $-O-$, $-SO_2-$, $CH_2$ und besonders $-CO-$ ist.

Ganz besonders bevorzugt sind Reste der Formeln

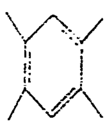

und

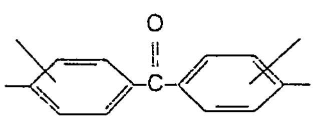

oder Mischungen davon, z. B. solche mit mindestens 5 Mol-% vierwertigen Benzophenonresten. Die freien Bindungen im Benzophenonrest befinden sich in Orthostellung.

Beispiele für Tetracarbonsäureanhydride mit einem Rest Z bzw. Z' sind:

2,3,9,10-Perylentetracarbonsäuredianhydrid,
1,4,5,8-Naphthalintetracarbonsäuredianhydrid,
2,6-Dichlornaphthalin-1,4,5,8-tetracarbonsäuredianhydrid,
2,7-Dichlornaphthalin-1,4,5,8-tetracarbonsäuredianhydrid,
2,3,6,7-Tetrachlornaphthalin-1,4,5,8-tetracarbonsäuredianhydrid,
Phenanthren-1,8,9,10-tetracarbonsäuredianhydrid,
Pyromellitsäuredianhydrid,
3,3',4,4'-Biphenyltetracarbonsäuredianhydrid,
2,2',3,3'-Biphenyltetracarbonsäuredianhydrid,
4,4'-Isopropylidendiphthalsäureanhydrid,
3,3'-Isopropylidendiphthalsäureanhydrid,
4,4'-Oxydiphthalsäureanhydrid,
4,4'-Sulfonyldiphthalsäureanhydrid,
3,3'-Oxydiphthalsäureanhydrid,
4,4'-Methylendiphthalsäureanhydrid,
4,4'-Thiodiphthalsäureanhydrid,
4,4'-Äthylidendiphthalsäureanhydrid,
2,3,6,7-Naphthalintetracarbonsäureanhydrid,
1,2,4,5-Naphthalintetracarbonsäuredianhydrid,
1,2,5,6-Naphthalintetracarbonsäuredianhydrid,
Benzol-1,2,3,4-tetracarbonsäuredianhydrid,
Thiophen-2,3,4,5-tetracarbonsäuredianhydrid,
1-(3',4'-Dicarboxyphenyl)-1,3,3-trimethylindan-5,6-dicarbonsäuredianhydrid,
1-(3',4'-Dicarboxyphenyl)-1,3,3-trimethylindan-6,7-dicarbonsäuredianhydrid,
1-(3',4'-Dicarboxyphenyl)-3-methylindan-5,6-dicarbonsäuredianhydrid,
1-(',4'-Dicarboxyphenyl)-3-methylindan-6,7-dicarbonsäuredianhydrid,
3,3',4,4'-Benzophenontetracarbonsäureanhydrid,
4,5,3',4'-Benzophenontetracarbonsäureanhydrid.

Die erfindungsgemäßen Polyimide weisen mittlere Molekulargewichte (Gewichtsmittel $\overline{M}w$) von mindestens 2000, vorzugsweise mindestens 5000 auf. Die obere Grenze richtet sich im wesentlichen nach Eigenschaften, die die Verarbeitbarkeit bestimmen, wie z. B. deren Löslichkeit. Sie kann bis zu 500 000, vorzugsweise bis zu 100 000 und besonders bis zu 60 000 betragen. Es kann sich ferner um statistische Polyimide oder um Blockpolyimide handeln. Sie werden nach üblichen Verfahren in hierfür vorgesehenen Einrichtungen hergestellt.

Ein weiterer Gegenstand vorliegender Erfindung ist ein Verfahren zur Herstellung von Polyimiden mit Strukturelementen der Formel I und/oder II, das dadurch gekennzeichnet ist, daß man mindestens eine Tetracarbonsäure der Formel V

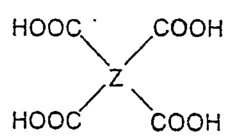

(V)

alleine oder zusammen mit mindestens einer Tetracarbonsäure der Formel Va, oder deren polyimidbildenden Derivate,

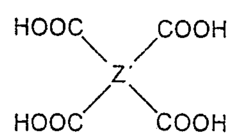

(Va)

mit mindestens 5 Mol-%, bezogen auf die Diamine, mindestens eines Diamines der Formel VI

$$H_2N-X-NH_2 \quad (VI)$$

alleine oder zusammen mit höchstens 95 Mol-% mindestens eines Diamines der Formel VIa

$$H_2N-X'-NH_2 \quad (VIa)$$

in an sich bekannter Weise polykondensiert und anschließend cyclisiert, sowie die nach diesem Verfahren erhältlichen Polyimide, die mindestens 5 Mol-% Strukturelemente der Formel I enthalten, worin Z den vierwertigen Rest eines Benzophenontetracarbonsäureanhydrides darstellt. Anstelle der Tetracarbonsäuren können auch deren polyimidbildende Derivate verwendet werden, wie z. B. deren Ester, Amide, Halogenide, besonders die Chloride, und Anhydride.

Die Ausgangsverbindungen sind bekannt, käuflich erhältlich oder nach bekannten Verfahren herstellbar. Die Reaktion wird vorteilhaft in Lösung durchgeführt; geeignete inerte Lösungsmittel sind nachfolgend genannt. Die Reaktionstemperaturen können −20 bis 300 °C betragen.

Im einzelnen geht man zweckmäßig so vor, daß man Tetracarbonsäuredianhydrid und Diamin zunächst unter Bildung einer Polyamidsäurevorstufe umsetzt und diese Polyamidsäure anschließend unter Wasserabspaltung cyclisiert. Die Cyclisierung kann thermisch erfolgen. Vorteilhaft wird die Cyclisierung unter Einwirkung von wasserentziehenden Mitteln, z. B. Carbonsäureanhydriden wie Acetanhydrid, vorgenommen. Die Polyimide können anschließend nach üblichen Verfahren, z. B. durch Entfernen des Lösungsmittels oder Ausfällen durch Zugabe eines Nichtlösungsmittels, isoliert werden.

Eine weitere Herstellungsmethode besteht darin, daß man das Tetracarbonsäuredianhydrid mit einem Diisocyanat in einer Stufe zum Polyimid umsetzt.

Die erfindungsgemäßen Polyimide sind in unterschiedlichen Lösungsmitteln löslich, gegebenenfalls unter Erwärmen, und sie weisen erhöhte Glasumwandlungstemperaturen auf, die bis über 500 °C betragen können. Sie eignen sich hervorragend zur Herstellung von Filmen und Schutzüberzügen, wobei Beschichtungsmittel aus einer Lösung des Polyimides in einem Lösungsmittel Anwendung finden können. Ein weiterer Gegenstand vorliegender Erfindung ist ein solches Beschichtungsmittel und die Verwendung der erfindungsgemäßen Polyimide zur Herstellung von Schutzüberzügen und Filmen.

Zur Herstellung des erfindungsgemäßen beschichteten Materials löst man das Polymer oder Gemische davon zweckmäßig in einem geeigneten organischen Lösungsmittel, gegebenenfalls unter Erwärmung. Geeignete Lösungsmittel sind z. B. polare, aprotische Lösungsmittel, die alleine oder in Mischungen aus mindestens zwei Lösungsmitteln verwendet werden können. Beispiele sind:
Äther wie Dibutyläther,
Tetrahydrofuran, Dioxan,
Methylenglykol, Dymethylenglykol,
Dimethyldiäthylenglykol,
Diäthyldiäthylenglykol,
Dimethyltriäthylenglykol,
halogenierte Kohlenwasserstoffe wie
Methylenchlorid, Chloroform,
1,2-Dichloräthan, 1,1,1-Trichloräthan,
1,1,2,2-Tetrachloräthan,
Carbonsäureester und Lactone wie
Essigsäureäthylester,
Propionsäuremethylester,
Benzoesäureäthylester,
2-Methoxyäthylacetat,
γ-Butyrolacton,
o-Valerolacten und Pivalolacton,
Carbonsäureamide und Lactame wie
Formamid, Acetamid, N-Methylformamid,
N,N-Dimethylformamid, N,N-Diäthylformamid,
N,N-Dimethylacetamid, N,N-Diäthylacetamid,
γ-Butyrolactam, ε-Caprolactam,
N-Methypyrrolidon, N-Acetylpyrrolidon,
N-Methylcaprolactam, Tetramethylharnstoff,
Hexamethylphosphorsäureamid,
Sulfoxide wie Dimethylsulfoxid,
Sulfone wie Dimethylsulfon,
Diäthylsulfon, Trimethylensulfon,
Tetramethylensulfon, Trimethylamin,
Triäthylamin, N-Methylpyrrolidin,
N-Methylpiperidin, N-Methylmorpholin,
substituierte Benzole wie Chlorbenzol,
Nitrobenzol, Phenole oder Kresole.

Ungelöste Anteile können durch Filtration, bevorzugt durch Druckfiltration entfernt werden. Die Konzentration an Polymer im so erhaltenen Beschichtungsmittel beträgt vorzugsweise nicht mehr als 50 Gew.-%, besonders nicht mehr als 30 Gew.-% und insbesondere nicht mehr als 20 Gew.-%, bezogen auf die Lösung.

Bei der Herstellung der Lösungen können weitere übliche Zusatzstoffe einverleibt werden, die die Lichtempfindlichkeit nicht negativ beeinflussen. Beispiele hierfür sind Mattierungsmittel, Verlaufmittel, feinteilige Füllstoffe, Flammschutzmittel, optische Aufheller, Antioxidantien, Lichtschutzmittel, Stabilisatoren, Farbstoffe, Pigmente Haftvermittler und Antihalofarbstoffe, wie sie z. B. in der US-PS 4 349 619 beschrieben sind.

Das Beschichtungsmittel kann mittels üblichen Methoden wie Tauch-, Streich- und Sprühverfahren, Schleuder-, Kaskadenguß- und Vorhanggußbeschichtung, auf geeignete Substrate bzw. Trägermaterialien, aufgebracht werden. Geeignete Substrate sind z. B. Kunststoffe, Metalle und Metallegierungen, Halbmetalle, Halbleiter, Glas, Keramik und andere anorganische Materialien wie z. B. $SiO_2$ und $Si_3N_4$. Danach wird das Lösungsmittel gegebenenfalls durch Erwärmen und gegebenenfalls im Vakuum entfernt. Man erhält klebfreie, trockene und gleichmäßige Filme. Die aufgebrachten Filme können je nach Anwendung Schichtdicken bis zu ca. 500 µm und mehr, bevorzugt von 0,5 bis 500 µm und besonders von 1 bis 50 µm aufweisen.

Es wurde gefunden, daß die erfindungsgemäßen Polyimide autophotovernetzbar sind und unter Strahlungseinwirkung vernetzt werden können, wenn sie mindestens 5 Mol-% Strukturelemente der Formel I enthalten, worin Z ein Rest einer Benzophenontetracarbonsäure ist. Da die Lichtempfindlichkeit mit steigendem Gehalt an solchen Strukturelementen steigt, ist ein Gehalt von mindestens 50 Mol-%, bevorzugt mindestens 80 Mol-% und besonders mindestens 90 Mol-% vorteilhaft.

Schutzfilme aus solchen Polyimiden können durch Strahlungseinwirkung weiter modifiziert werden, womit z.B. erhöhte Thermostabilitäten möglich sind. Ferner besteht die Möglichkeit, solche Polyimide als photographisches Aufzeichnungsmaterial für Reliefabbildungen einzusetzen. Durch die Direktvernetzung unter Strahlungseinwirkung können Zusätze wie Sensibilisatoren vermieden werden und die Schutzschichten und Abbildungen weisen ausgezeichnete elektrische Eigenschaften auf. Weiter zeichnen sich die Schutzschichten und Abbildungen durch ihre hohe Thermostabilität aus sowie durch keinen oder nur einen geringen Schwund bei thermischer Belastung, was in der Anwendung erhebliche Vorteile hat, weil praktisch keine Verzerrung abgebildeter Strukturen beobachtet wird.

Ein weiterer Gegenstand der Erfindung sind Beschichtungsmittel, die in Lösung ein solches strahlungsempfindliches Polyimid enthalten, ein mit solchen Polyimiden beschichtetes Trägermaterial und die Verwendung dieses Materials zur Herstellung von Schutzschichten und photographischen Reliefabbildungen. Die Schichtdicke beträgt für diese Anwendung bevorzugt 0,5 bis 100 µm, besonders 1 bis 50 µm und insbesondere 1–10 µm.

Die Photostrukturierung bzw. Photovernetzung kann durch energiereiche Strahlung hervorgerufen werden, z.B. durch Licht insbesondere im UV-Bereich, durch Röntgenstrahlen, Laserlicht, Elektronenstrahlen usw. Das erfindungsgemäße Material eignet sich hervorragend zur Herstellung von Schutzfilmen, Passivierlacken, und als photographisches Aufzeichnungsmaterial für thermostabile Reliefabbildungen.

Anwendungsgebiete sind z.B. Schutz-, Isolier- und Passivierlacke in der Elektrotechnik und Elektronik, Photomasken für die Elektronik, den Textildruck und das graphische Gewerbe, Ätzresist zur Herstellung gedruckter Schaltungen und Druckplatten und integrierter Schaltkreise, Relais für die Herstellung von Röntgenmasken, als Lötstopplack, als Dielektrikum für Mehrlagenschaltungen, als Strukturelement für Flüssigkristallanzeiger.

Die Herstellung von Schutzfilmen erfolgt durch direktes Belichten, wobei sich die Belichtungszeiten im wesentlichen nach den Schichtdicken und der Lichtempfindlichkeit richten.

Die photographische Erzeugung der Reliefstruktur erfolgt durch bildmäßige Belichtung durch eine Photomaske, anschließende Entwicklung unter Entfernung der unbelichteten Anteile mit einem Lösungsmittel oder einem Lösungsmittelgemisch, wonach gegebenenfalls das erzeugte Bild durch eine thermische Nachbehandlung stabilisiert werden kann.

Ein weiterer Gegenstand der Erfindung ist ein solches Verfahren zum Aufbringen von Reliefstrukturen. Als Entwickler sind z.B. die zuvor erwähnten Lösungsmittel geeignet.

Die Polymerschicht des erfindungsgemäßen Materials weist eine für viele Anwendungszwecke ausreichende und teilweise hohe Lichtempfindlichkeit auf und sie kann direkt photovernetzt werden. Die Schutzfilme und Reliefabbildungen zeichnen sich durch hohe Haftfestigkeit und thermische, mechanische und chemische Widerstandsfähigkeit aus. Bei thermischen Nachbehandlungen wird nur ein geringer Schwund beobachtet. Ferner können Zusätze zur Erzeugung bzw. Steigerung der Lichtempfindlichkeit vermieden werden. Das Material ist lagerstabil, aber vorteilhaft vor Lichteinwirkung zu schützen.

Die nachfolgenden Beispiele erläutern die Erfindung näher.

A) Herstellungsbeispiele

Beispiel 1

In einem zylindrischen Gefäß, das mit Rührer, Tropftrichter, Innenthermometer und Stickstoffeinleitungsrohr ausgestattet ist, werden unter Stickstoff 10,16 g (0,04 Mol) 4,4′-Diamino-3,3′,5,5′-tetramethyldiphenylmethan in 130 ml N-Methylpyrrolidon (NMP) gelöst und auf 0 bis 5 °C abgekühlt. Nun werden 12,88 g (0,04 Mol) Benzophenontetracarbonsäuredianhydrid (BTDA) bereitgestellt und in Portionen im Verlaufe von 4 Stunden zugesetzt. 30 Minuten nach dem letzten Zusatz werden 8,9 g Triäthylamin (0,09 Mol) und 36,7 g (0,36 Mol) Acetanhydrid zugetropft, um die entstandene Polyamidsäure zum Polyimid zu cyclisieren. Nach 16 Stunden Rühren bei Raumtemperatur wird die Lösung unter starkem Rühren auf 2 l Wasser gegossen und das ausgefallene Produkt abfiltriert. Das Produkt wird erneut mit 2 l Wasser behandelt, filtriert und bei 80 °C im Vakuum getrocknet. Die Inhärente Viskosität, gemessen als 0,5%-ige Lösung in NMP bei 25 °C beträgt 0,79 dl/g. Die Glasumwandlungstemperatur (Tg), gemessen durch Differential-Scanning-Calometrie (DSC) beträgt 309 °C.

Beispiel 2

Es wird wie in Beispiel 1 verfahren, aber ein Gemisch aus 50 Mol-% BTDA und 50 Mol-% Pyromellitsäuredianhydrid (PMDA) eingesetzt. Eigenschaften des erhaltenen Copolyimides:

$\eta$ = 0,75 dl/g
Tg = 403 °C.

Beispiele 3 bis 26

Gemäß Beispiel 1 werden verschiedene Diamine oder Diamingemische mit einer äquivalenten Menge BTDA umgesetzt und anschließend zum Polyimid cyclisiert. Die Diamine und die Eigenschaften der daraus resultierenden Polyimide sind in Tabelle 1 zusammengefaßt.

Tabelle 1

| Beispiel | Diamin | $\eta$ inh. (dl/g) | Tg (°C) |
|---|---|---|---|
| 3 | 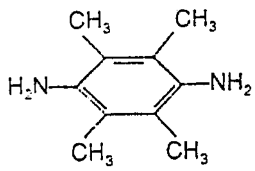 | 0,92 | 439 |
| 4 | 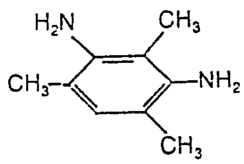 | 0,64 | 408 |
| 5 | 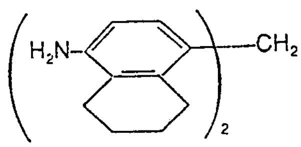 | 0,70 | 310 |
| 6 | 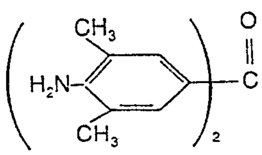 | 0,25 | 326 |
| 7 | 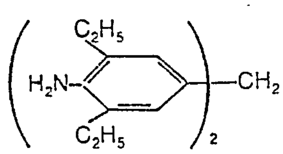 | 0,51 | 260 |
| 8 | 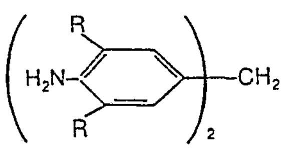 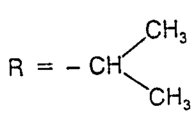 | 0,56 | 283 |
| 9 | Diamin Beispiel 1 (50 Mol%)<br>Diamin Beispiel 3 (50 Mol%) | 0,76 | 377 |
| 10 | Diamin Beispiel 7 (50 Mol%)<br>Diamin Beispiel 3 (50 Mol%) | 0,62 | 323 |

Tabelle 1 (Fortsetzung)

| Beispiel | Diamin | η inh. (dl/g) | Tg (°C) |
|---|---|---|---|
| 11 | 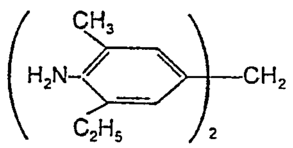 (50 Mol%)<br>Diamin Beispiel 3 (50 Mol%) | 0,78 | 364 |
| 12 | 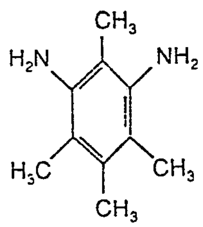 | 0,592 | 429 |
| 13 | 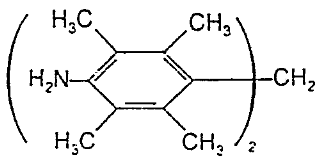 | 0,773 | 392 |
| 14 | 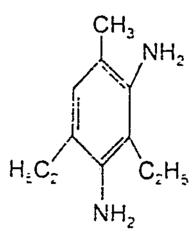 | 0,606 | 390 |
| 15 | 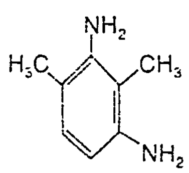 | 0,438 | 386 |
| 16 | 3,6-Diaminodurol (70 Mol%)<br>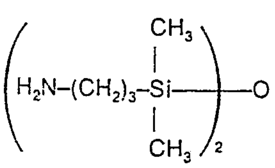<br>(30 Mol%) | 0,705 | 276 |
| 17 | 3.6-Diaminodurol (87.2 Mol%)<br>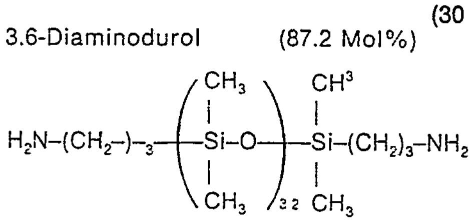<br>(12,8 Mol%) | 0,525 | 342 |

Tabelle 1 (Fortsetzung)

| Beispiel | Diamin | η inh. (dl/g) | Tg (°C) |
|---|---|---|---|
| 18 | 3,6-Diaminodurol (70 Mol%)<br>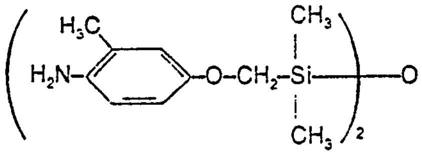<br>(30 Mol%) | 0,441 | 305 |
| 19[1] | 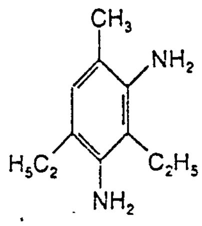 (80 Mol%)<br>$H_2N-(CH_2)_6-NH_2$ (20 Mol%) | 0,48 | 329 |
| 20[1] | 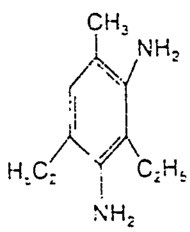 (90 Mol%)<br>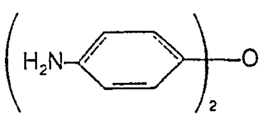 (10 Mol%) | 0,534 | 386 |
| 21 | 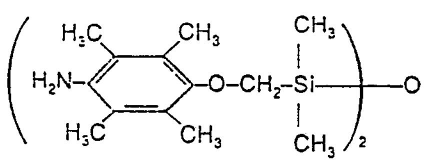 | 0,08 | 130 |
| 22 | 3,6-Diaminodurol (90 Mol%)<br>Diamin aus Beispiel 21 (10 Mol% | 0,397 | 377 |
| 23 | 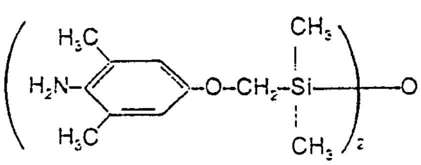 | 0,189 | 154 |

[1] 10 Mol% BTDA durch PMDA ersetzt

Tabelle 1 (Fortsetzung)

| Beispiel | Diamin | | η inh. (dl/g) | Tg (°C) |
|---|---|---|---|---|
| 24 | 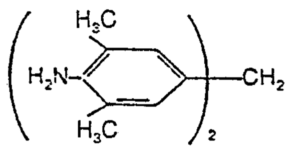 | (60 Mol%) | 0,303 | 230 |
| | Diamin aus Beispiel 23 | (40 Mol%) | | |
| 25 | 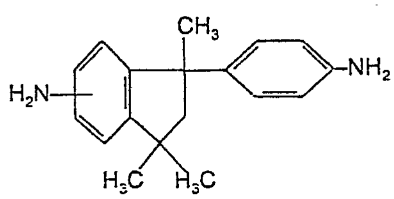 | (80 Mol%) | 0,60 | 333 |
| | 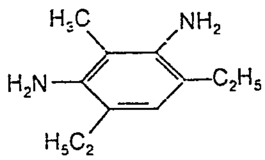 | (20 Mol%) | | |
| 26 | 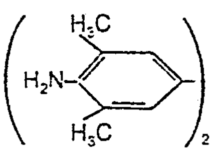 | (20 Mol%) | 0,425 | 378 |
| | 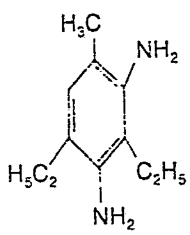 | (80 Mol%) | | |

Beispiel 27

In der in Beispiel 1 beschriebenen Apparatur werden 4,89 g (0,017 Mol) 4,4'-Diamino-3,3'-dimethyl-5,5'-diäthyldiphenylmethan mit 5,57 g BTDA in 42 ml NMP umgesetzt. Nach 2 Stunden wird die Temperatur auf 50 °C erhöht. Nach einer Stunde werden 55,7 mg BTDA zugesetzt und weitere 3 Stunden bei 50 °C gerührt. Nach erneutem Zusatz von 55,7 mg BTDA wird nochmals 2 Stunden bei 50 °C weitergerührt. Nach Abkühlen auf Raumtemperatur werden 5,5 ml Triäthylamin und 15 ml Acetanhydrid zugegeben und über Nacht bei Raumtemperatur gerührt. Am nächsten Tag wird das Polymer durch Einrühren in Wasser ausgefällt, filtriert und getrocknet. Eigenschaften:

η = 0,70 dl/g

Tg = 282 °C.

B) Anwendungsbeispiele

Auf einer einseitig Kupfer-kaschierten Kunststoffplatte wird ein dünner Polymerfilm erzeugt, indem eine 5%-ige Polymerlösung aufgeschleudert wird und das Lösungsmittel anschließend in einem Umluftofen entfernt wird. Als Lösungsmittel wird N-Methylpyrrolidon verwendet.

Die so beschichteten Platten werden durch eine Photomaske (Stouffer-Keil) bei Raumtemperatur mit einer 1000 Watt-UV-Lampe aus 18 cm Entfernung belichtet. Die belichteten Platten werden anschließend mit einem Lösungsmittel entwickelt, wobei die unbelichteten Anteile des Polymerfilms weggelöst werden. Die Sichtbarmachung des Reliefbildes geschieht anschließend durch Wegätzen der freigelegten Kupferschicht mit $FeCl_3$-Lösung.

Die Belichtungszeit, der verwendete Entwickler und die Photoempfindlichkeit (21-step Stouffer sensitivity guide) sind in Tabelle 2 zusammengefaßt. MEK ist Methyläthylketon.

Tabelle 2

| Polymer gemäss Beispiel | Belichtungs-zeit (Sekunden) | Entwickler | Empfind-lichkeit (Stouffer-Skala) |
|---|---|---|---|
| 1 | 10 | NMP | 6 |
| 2 | 40 | NMP | 7 |
| 3 | 20 | NMP | 7–8 |
| 4 | 10 | NMP | 5 |
| 5 | 10 | NMP | 6–7 |
| 6 | 120 | NMP | 9–10 |
| 7 | 4 | NMP | 6 |
| 8 | 10 | NMP | 9 |
| 9 | 5 | NMP | 7 |
| 10 | 4 | NMP | 6 |
| 11 | 15 | NMP | 8–9 |
| 12 | 15 | NMP | 6 |
| 13 | 6 | NMP | 6 |
| 14 | 10 | NMP | 7 |
| 15 | 120 | NMP | 5 |
| 16 | 30 | NMP | 8 |
| 17 | 30 | NMP | 6 |
| 18 | 240 | $CHCl_3$ | 5 |
| 19 | 120 | NMP | 6 |
| 20 | 130 | NMP | 5 |
| 21 | 600 | Toluol | 3 |
| 22 | 120 | NMP | 8 |
| 23 | 600 | Toluol | 6–7 |
| 24 | 240 | NMP | 6–7 |
| 25 | 600 | $CHCl_3$ | 2 |
| 26 | 120 | NMP | 5–6 |
| 27 | 2,5 | NMP/MEK (1:2) | 6 |

**Patentansprüche**

1. Homo- und Copolyimide aus mindestens einer aromatischen Tetracarbonsäure und mindestens einem aromatischen Diamin, die aus 5 bis 100 Mol-% mindestens eines Strukturelementes der Formel I

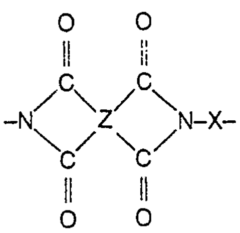
(I)

und 95–0 Mol-% mindestens eines Strukturelementes der Formel II

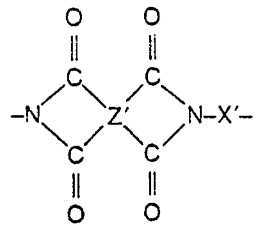
(II).

bestehen, worin

Z einen unsubstituierten oder substituierten vierwertigen aromatischen Rest darstellt, an den je zwei Carbonylgruppen in Ortho- oder Peristellung gebunden sind,

X den zweiwertigen Rest eines aromatischen Diamines bedeutet,

Z′ die gleiche Bedeutung wie Z hat, oder ein von Z verschiedener vierwertiger aromatischer Rest ist, und

X′ der zweiwertige, von X verschiedene Rest eines organischen Diamines ist, dadurch gekennzeichnet, daß der aromatische Rest von X in beiden Orthostellungen zu mindestens einem N-Atom durch Alkyl, Cycloalkyl, Alkoxy, Alkoxyalkyl, oder Aralkyl substituiert ist, oder daß zwei benachbarte C-Atome des aromatischen Restes durch Alkylen verbunden sind, mit der Maßgabe, daß mindestens 5 Mol%, bezogen auf die Tetracarbonsäurereste, an Benzophenontetracarbonsäureresten im Polyimid zugegeben sind.

2. Polyimide gemäß Anspruch 1, dadurch gekennzeichnet, daß X als aromatischer Rest einen zweiwertigen, ein- oder zweikernigen Phenylenrest darstellt.

3. Polyimide gemäß Anspruch 1, dadurch gekennzeichnet, daß der Substituent von X als Alkyl oder Alkoxy 1 bis 20 C-Atome, als Alkoxyalkyl 2 bis 12 C-Atome, als Cycloalkyl 5 oder 6 Ringkohlenstoffatome und als Alkylen 3 oder 4 C-Atome enthält und als Aralkyl Benzyl ist.

4. Polyimide gemäß Anspruch 3, dadurch gekennzeichnet, daß der Substituent Alkyl mit 1 bis 4 C-Atomen, bevorzugt Isopropyl, Äthyl und besonders Methyl ist.

5. Polyimide gemäß Anspruch 1, dadurch gekennzeichnet, daß Z und Z′ als aromatischer Rest 6 bis 30 C-Atome enthält.

6. Polyimide gemäß Anspruch 1, dadurch gekennzeichnet, daß Z und Z′

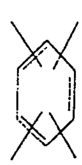
,
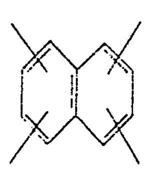
,

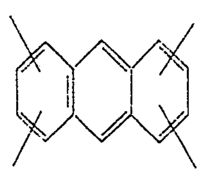
,
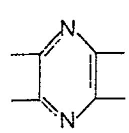
,
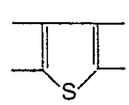

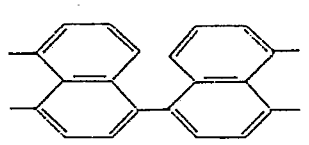,
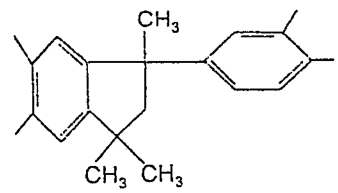

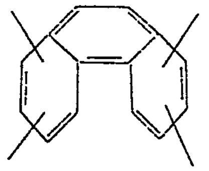.
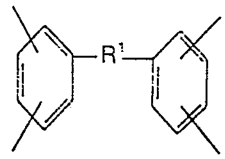

sind,
worin $R^1$ eine direkte Bindung oder eine Brückengruppe der Formeln

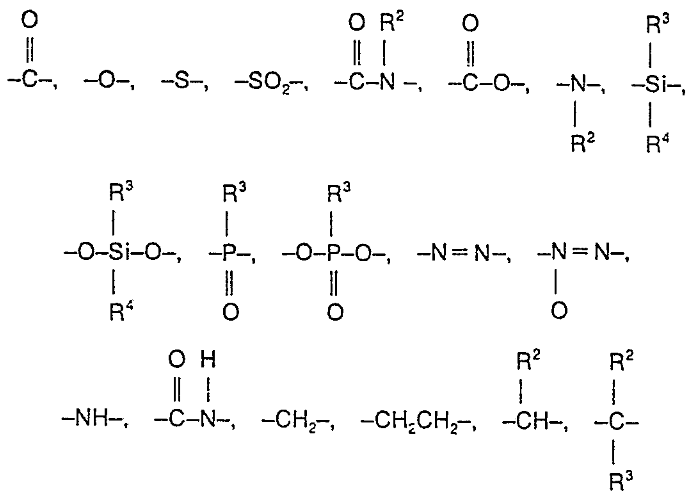

sind, worin $R^2$, $R^3$ und $R^4$ Alkyl mit 1 bis 6 C-Atomen, Phenyl oder Benzyl und $R^3$ und $R^4$ auch Alkoxy mit 1 bis 6 C-Atomen, Phenyloxy oder Benzyloxy sind.

7. Polyimide gemäß Anspruch 6, dadurch gekennzeichnet, daß Z und Z' ein Rest der Formeln

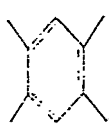 oder 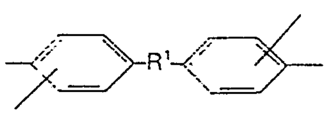

sind, worin $R^1$ eine direkte Bindung, –O–, $–SO_2–$, $CH_2$ und besonders –CO– ist.

8. Polyimide gemäß Anspruch 7, dadurch gekennzeichnet, dass Z und Z' ein Rest der Formeln

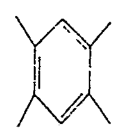 und 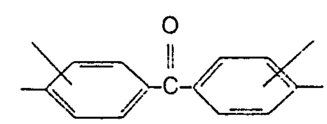

oder Mischungen davon sind.

9. Polyimide gemäß Anspruch 1, dadurch gekennzeichnet, daß X als aromatischer Rest den Formeln III, IIIa und/oder IIIb entspricht,

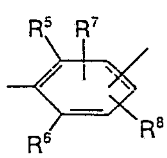 (III) 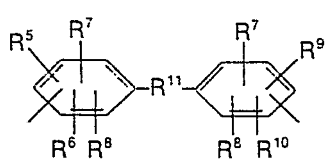 (IIIa) 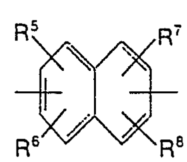 (IIIb)

worin in Formel III die freien Bindungen in Meta- oder Parastellung zueinander stehen, in Formel IIIa die freien Bindungen bevorzugt in Meta- oder Parastellung zur $R^{11}$-Gruppe stehen und $R^5$ und $R^6$ in den beiden Orthostellungen der freien Bindung gebunden sind, und in Formel IIIb die freien Bindungen in 2-, 3-, 6- und 7-Stellung gebunden sind und $R^5$ und $R^6$ sich in den beiden Orthostellungen der freien Bindungen befinden, $R^{11}$ für eine direkte Bindung, –O–, –S–, –SS–, –SO–, $–SO_2–$, –CO–, –COO–, –NH–, –N-Alkyl mit 1 bis 6 C-Atomen im

Alkyl, -N-Phenyl, -N-Benzyl, –CONH–, –CON-Alkyl- mit 1 bis 6 C-Atomen im Alkyl, –CON-Phenyl-, –CON-Benzyl-,

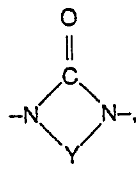, worin Y für 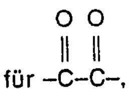, 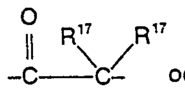 oder 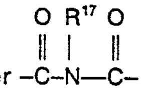 steht und

$R^{17}$ ein Wasserstoffatom, $C_1$–$C_6$-Alkyl oder Phenyl bedeutet, lineares oder verzweigtes Alkylen mit 1 bis 3 C-Atomen, gegebenenfalls durch Cl oder F substituiertes Alkyliden mit 2 bis 12 C-Atomen, Cycloalkyliden mit 5 oder 6 Ringkohlenstoffatomen, Phenylen, Phenylendioxy, oder die Gruppe

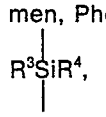,

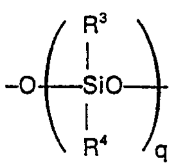 oder 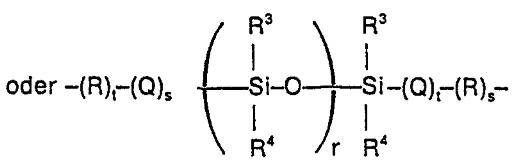 steht, worin $R^3$

und $R^4$ Alkyl oder Alkoxy mit 1 bis 6 C-Atomen, Phenyl, Benzyl, Phenyloxy oder Benzyloxy sind, r eine Zahl von 1 bis 10, t 0 oder 1 und S 0 oder 1 ist, und R –O– oder –S– und Q $C_1$–$C_6$-Alkylen bedeuten, und q für eine Zahl von 1 bis 100 steht, $R^5$ und $R^6$ Alkyl oder Alkoxy, mit 1 bis 12 C-Atomen, Alkoxyalkyl mit 2 bis 12 C-Atomen Cyclopentyl, Cyclohexyl oder Benzyl sind oder in den Formeln III oder IIIa $R^5$ und $R^7$ in Nachbarstellung gebunden sind und zusammen Trimethylen oder Tetramethylen bedeuten, wobei $R^6$ auch ein Wasserstoffatom sein kann, $R^7$ und $R^8$ ein Wasserstoffatom sind oder unabhängig die Bedeutung von $R^5$ und $R^6$ haben, und $R^9$ und $R^{10}$ ein Wasserstoffatom sind, unabhängig die Bedeutung von $R^5$ und $R^6$ haben oder $R^7$ und $R^9$ in Formel IIIa zusammen Trimethylen oder Tetramethylen sind.

10. Polyimide gemäß Anspruch 9, dadurch gekennzeichnet, daß $R^5$ und $R^6$ Alkyl mit 1 bis 6 C-Atomen, besonders Methyl, Äthyl n-Propyl oder Isopropyl sind.

11. Polyimide gemäß Anspruch 9, dadurch gekennzeichnet, daß $R^{11}$ –$CH_2$–, –O–, –CO– oder eine direkte Bindung darstellt.

12. Polyimide gemäß Anspruch 9, dadurch gekennzeichnet, daß in Formel IIIa die freien Bindungen in Parastellung zur $R^{11}$-Gruppe stehen.

13. Polyimide gemäß Anspruch 1, dadurch gekennzeichnet, daß sie mindestens 2, bevorzugt 2 bis 4 verschiedene Strukturelemente enthalten.

14. Polyimide gemäß Anspruch 13, dadurch gekennzeichnet, daß sich die Strukturelemente der Formel I im Rest X unterscheiden.

15. Polyimide gemäß Anspruch 9, dadurch gekennzeichnet, daß X in Formel I Resten der Formeln

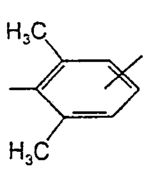, 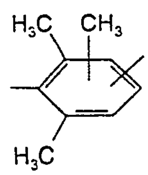, 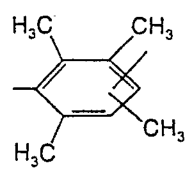, 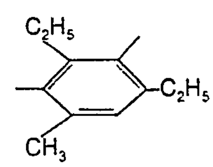

entsprechen, worin die freien Bindungen in Meta- oder Parastellung zueinander stehen, oder der Formel

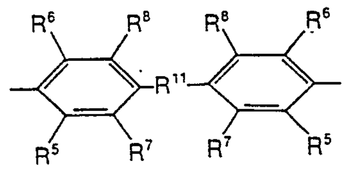

entsprechen, worin $R^5$ und $R^6$ unabhängig Methyl, Äthyl, n-Propyl oder Isopropyl und $R^7$ und $R^8$ ein Wasserstoffatom sind oder die Bedeutung von $R^5$ haben oder $R^5$ und $R^7$ zusammen Tri- oder Tetramethylen bedeuten und $R^6$ und $R^8$ ein Wasserstoffatom sind, und $R^{11}$ eine direkte Bindung, $CH_2$ oder CO ist.

16. Polyimide gemäß Anspruch 15, dadurch gekennzeichnet, daß es ein Copolyimid mit zwei oder mehr Resten der Formeln

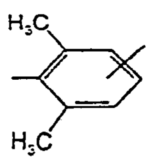,
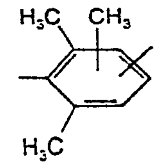,
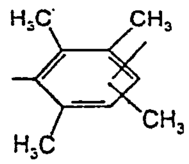,
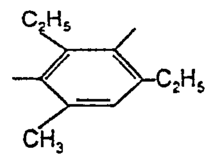

worin die freien Bindungen in Meta- oder Parastellung zueinander stehen, oder der Formel

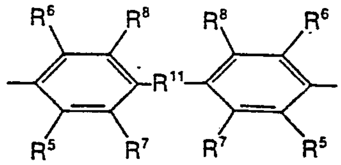

ist, worin $R^5$, $R^6$, $R^7$, $R^8$ und $R^{11}$ die im Anspruch 15 angegebene Bedeutung haben.

17. Polyimide gemäß Anspruch 1, dadurch gekennzeichnet, daß X' in Formel II Alkylen mit 2 bis 30 C-Atomen, Cycloalkylen mit 5 bis 8 Ringkohlenstoffatomen, Aralkylen mit 7 bis 30 C-Atomen, Arylen mit 6 bis 22 C-Atomen oder ein Polysiloxanrest ist.

18. Polyimide gemäß Anspruch 17, dadurch gekennzeichnet, daß X' als Arylen der Formel IV entspricht,

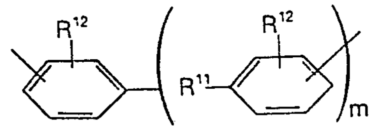 (IV)

worin m 0 oder 1 ist, die freien Bindungen in Meta- und bevorzugt in Orthostellung zur $R^{12}$-Gruppe gebunden sind, $R^{11}$ die gleiche Bedeutung wie in Formel IIIa hat und $R^{12}$ die gleiche Bedeutung wie $R^5$ hat.

19. Polyimide gemäß Anspruch 18, dadurch gekennzeichnet, daß X' der Formel IVa, IVb und/oder IVc entspricht,

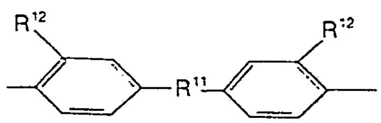 (IVa),
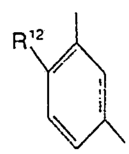 (IVb),
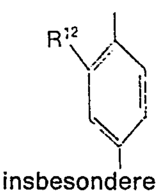 (IVc),

worin $R^{11}$ für eine direkte Bindung, –O–, –CO– oder $-CH_2-$ steht und $R^{12}$ Methyl, Äthyl, Isopropyl, Methoxy, Äthoxy oder ein Wasserstoffatom bedeutet.

20. Polyimide gemäß Anspruch 1, dadurch gekennzeichnet, daß sie 20–100 Mol%, insbesondere 50–100 Mol%, Strukturelemente der Formel I und 80–0 Mol%, insbesondere 50–0 Mol%, Strukturelemente der Formel II enthalten.

21. Polyimide gemäß Anspruch 1, dadurch gekennzeichnet, daß sie aus wiederkehrenden Strukturelementen der Formeln

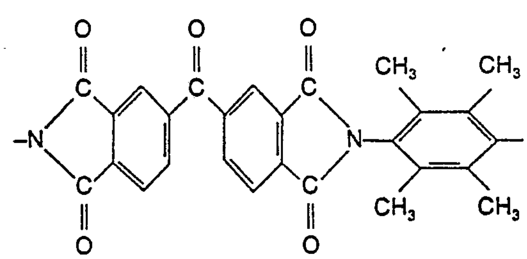

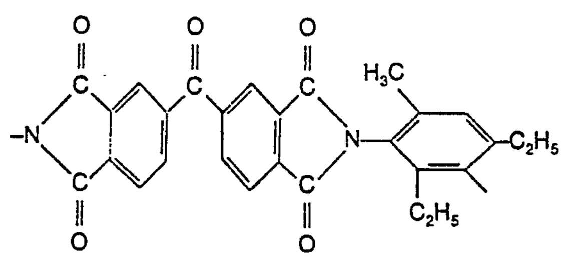

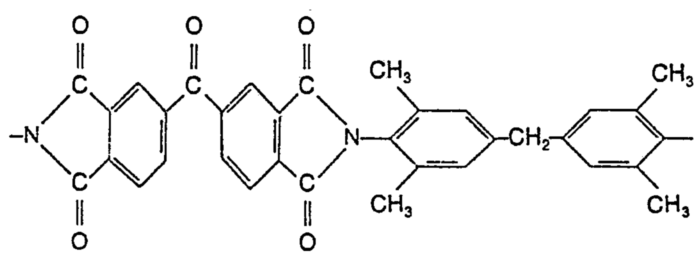

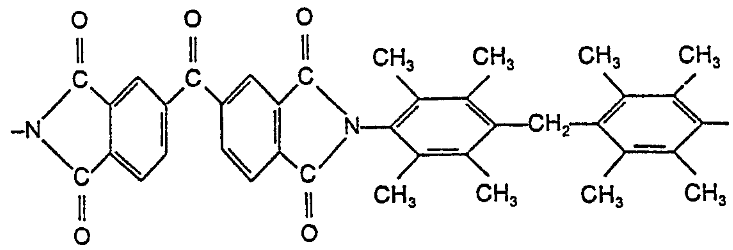

oder Mischungen solcher Strukturelemente bestehen.

22. Verfahren zur Herstellung von Polyimiden gemäß Anspruch 1, das dadurch gekennzeichnet ist, daß man mindestens eine Tetracarbonsäure der Formel V

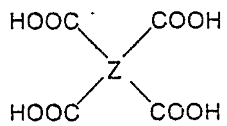
(V)

alleine oder zusammen mit mindestens einer Tetracarbonsäure der Formel Va, oder deren polyimidbildenden Derivate,

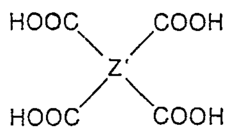
(Va)

mit mindestens 5 Mol-%, bezogen auf die Diamine, mindestens eines Diamines der Formel VI

$$H_2N\text{–}X\text{–}NH_2 \qquad (VI)$$

alleine oder zusammen mit höchstens 95 Mol-% mindestens eines Diamines der Formel VIa

$$H_2\text{–}X'\text{–}NH_2 \qquad (VIa),$$

worin Z, Z', X und X' die in Anspruch 1 definierte Bedeutung besitzen, in an sich bekannter Weise polykondensiert und anschließend cyclisiert.

23. Beschichtetes Material aus einem Trägermaterial, auf dem eine Schicht eines Polyimides gemäß der Ansprüche 1 oder 21 aufgebracht ist.

24. Verfahren zur Herstellung vernetzter Polyimide, dadurch gekennzeichnet, daß man ein Polyimid gemäß Anspruch 1 mit energiereicher Strahlung bestrahlt.

25. Verfahren zur Herstellung von Reliefstrukturen umfassend die bildmäßige Belichtung eines beschichteten Materials gemäß Anspruch 23 mit energiereicher Strahlung durch eine Photomaske, anschließende Entwicklung und gegebenenfalls thermische Nachbehandlung.

26. Verfahren zur Herstellung von Schutzfilmen umfassend das direkte Bestrahlen eines beschichteten Materials gemäß Anspruch 23 mit energiereicher Strahlung.

27. Verwendung von Polyimiden gemäß Anspruch 1 zur Herstellung von Schutzfilmen oder photographischen Reliefabbildungen.

**Claims**

1. A homopolyimide o copolyimide of at least one aromatic tetracarboxylic acid and at least one aromatic diamine, which consists of 5 to 100 mol % of at least one structural element of the formula I

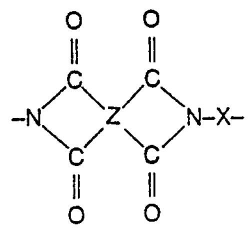
(I)

and 95–0 mol % of at least one structural element of the formula II

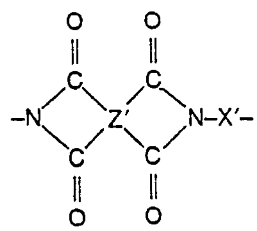
(II),

in which Z is an unsubstituted or substituted tetravalent aromatic radical to which in each case two carbonyl groups are bonded in the ortho- or peri-position, X is the divalent radical of an aromatic diamine, Z' has the same meaning as Z, or is a different tetravalent aromatic radical to Z, and X' is the divalent radical of an organic diamine which differs from X, wherein the aromatic radical of X is substituted in the two ortho-positions relative to at least one N atom by alkyl, cycloalkyl, alkoxy, alkoxyalkyl or aralkyl, or wherein two adjacent C atoms of the aromatic radical are connected by alkylene, with the proviso that at least 5 mol %, based on the tetracarboxylic acid radicals, of benzophenonetetracarboxylic acid radicals are present in the polyimide.

2. A polyimide according to claim 1, wherein an aromatic radical X is a divalent, mononuclear or dinuclear phenylene radical.

3. A polyimide according to claim 1, wherein the alkyl or alkoxy substituent of X contains 1 to 20 C atoms, the alkoxyalkyl substituent of X contains 2 to 12 C atoms, the cycloalkyl substituent of X contains 5 or 6 ring carbon atoms, the alkylene substituent of X contains 3 or 4 C atoms and the aralkyl substituent of X is benzyl.

4. A polyimide according to claim 3, wherein the substituent is alkyl with 1 to 4 C atoms, preferably isopropyl, ethyl or, in particular, methyl.

5. A polyimide according to claim 1, wherein an aromatic radical Z or Z′ contains 6 to 30 C atoms.

6. A polyimide according to claim 1, wherein Z and Z′ are

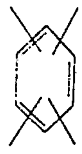, 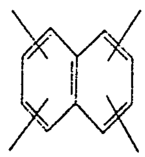,

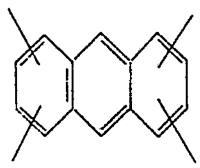, 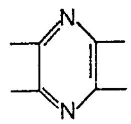, 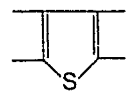

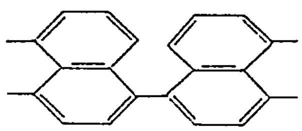, 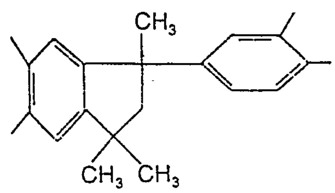

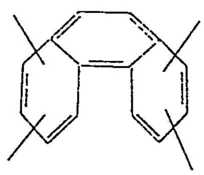, 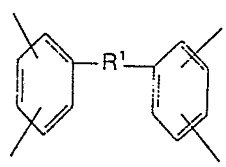

in which $R^1$ is a direct bond or a bridge group of the formula

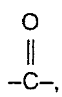, $-O-$, $-S-$, $-SO_2-$, 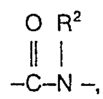, 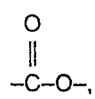, 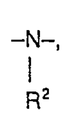, 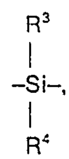,

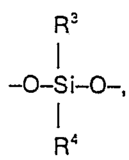, 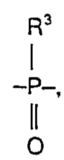, 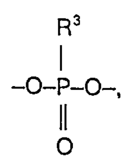, $-N=N-$, 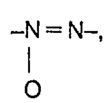,

$-NH-$, 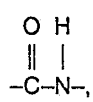, $-CH_2-$, $-CH_2CH_2-$, 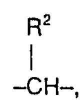, 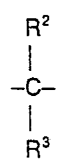

in which $R^2$, $R^3$ and $R^4$ are alkyl with 1 to 6 C atoms, phenyl or benzyl, and $R^3$ and $R^4$ are also alkoxy with 1 to 6 C atoms, phenoxy or benzyloxy.

7. A polyimide according to claim 6, wherein Z and Z′ are radicals of the formulae

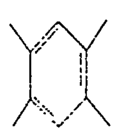 and/or 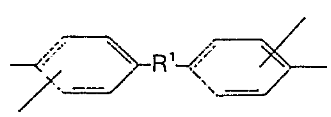

in which $R^1$ is a direct bond, $-O-$, $-SO_2-$, $-CH_2-$ or, in particular, $-CO-$.

8. A polyimide according to claim 7, wherein Z and Z′ are radicals of the formulae

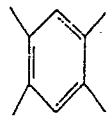 and/or 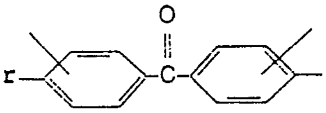

or mixtures thereof.

9. A polyimide according to claim 1, wherein an aromatic radical X has the formulae III, IIIa and/or IIIb

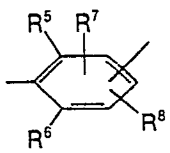 (III) 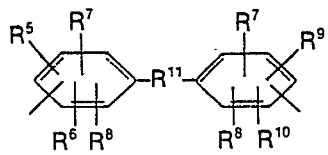 (IIIa) 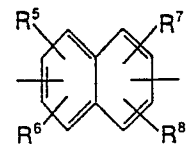 (IIIb)

in which, in formula III, the free bonds are in the meta- or para-position relative to one another, in formula IIIa the free bonds are preferably in the meta- or para-position relative to the $R^{11}$ group and $R^5$ and $R^6$ are bonded in the two ortho-positions of the free bond, and in formula IIIb the free bonds are in the 2-, 3-, 6- or 7-positions and $R^5$ and $R^6$ are in the two ortho-positions of the free bonds, $R^{11}$ is a direct bond, $-O-$, $-S-$, $-SS-$, $-SO-$, $-SO_2-$, $-CO-$, $-COO-$, $-NH-$, $-N$-alkyl with 1 to 6 C atoms in the alkyl, N-phenyl, N-benzyl, $-CONH-$, $-CON$-alkyl- with 1 to 6 C atoms in the alkyl, $-CON$-phenyl-, $-CON$-benzyl-,

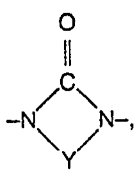, in which Y is 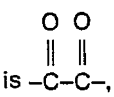, 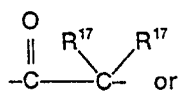 or 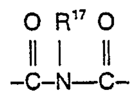 and

$R^{17}$ is a hydrogen atom, $C_1$–$C_6$alkyl or phenyl, linear or branched alkylene with 1 to 3 C atoms, alkylidene which has 2 to 12 C atoms and is unsubstituted or substituted by Cl or F, cycloalkylidene with 5 or 6 ring carbon atoms, phenylene, phenylenedioxy or the group

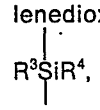,

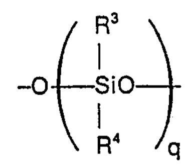 or $-(R)_t-(Q)_s$ 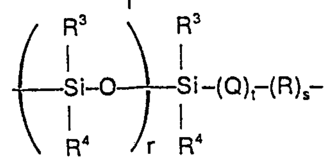 in which $R^3$ and $R^4$ are alkyl or alkoxy with 1 to 6 C atoms, phenyl, benzyl, phenoxy or benzyloxy, r is a number from 1 to 10, t is 0 or 1, s is 0 or 1, R is $-O-$ or $-S-$, Q is $C_1$–$C_6$alkylene and q is a number from 1 to 100, $R^5$ and $R^6$ are alkyl or alkoxy with 1 to 12 C atoms, alkoxyalkyl with 2 to 12 C atoms, cyclopentyl, cyclohexyl or benzyl, or, in the formula III or IIIa, $R^5$ and $R^7$ are bonded in adjacent positions and together are trimethylene or tetramethylene, in which case $R^6$ can also be a hydrogen atom, or $R^7$ and $R^8$ are hydrogen atoms or independently have the meanings of $R^5$ and $R^6$, and $R^9$ and $R^{10}$ are hydrogen atoms or independently have the meanings of $R^5$ and $R^6$, or $R^7$ and $R^9$ in formula IIIa together are trimethylene or tetramethylene.

10. A polyimide according to claim 9, wherein $R^5$ and $R^6$ are alkyl with 1 to 6 C atoms, in particular methyl, ethyl, n-propyl or isopropyl.

11. A polyimide according to claim 9, wherein $R^{11}$ is $-CH_2-$, $-O-$, $-CO-$ or a direct bond.

12. A polyimide according to claim 9, wherein the free bonds in formula IIIa are in the para-position relative to the $R^{11}$ group.

13. A polyimide according to claim 1, which contains at least 2, preferably 2 to 4, different structural elements.

14. A polyimide according to claim 13, wherein the structural elements of the formula I differ in the radical X.

15. A polyimide according to claim 9, wherein X in formula I is a radical of the formula

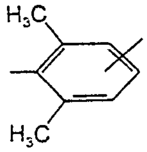, 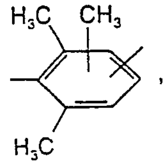, 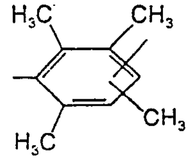, 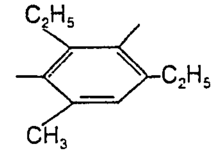

in which the free bonds are in the meta- or para-position relative to one another, or of the formula

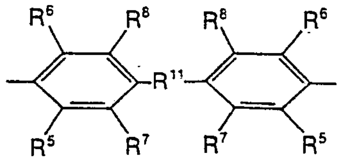

in which $R^5$ and $R^6$ independently of one another are methyl, ethyl, n-propyl or isopropyl, $R^7$ and $R^8$ are hydrogen atoms or have the meaning of $R^5$, or $R^5$ and $R^7$ together are trimethylene or tetramethylene and $R^6$ and $R^8$ are hydrogen atoms, and $R^{11}$ is a direct bond, $CH_2$ or CO.

16. A polyimide accordiang to claim 15, which is a copolyimide with two or more radicals of the formulae

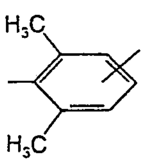 , 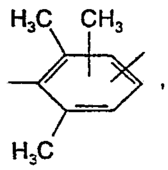 , 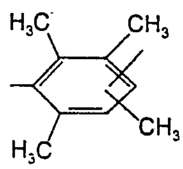 , 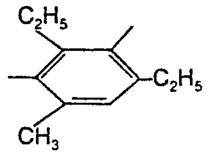

in which the free bonds are in the meta- or para-position relative to one another, or of the formula

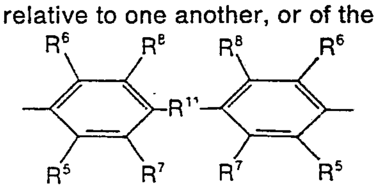

in which $R^5$, $R^6$, $R^7$, $R^8$ and $R^{11}$ are as defined in claim 15.

17. A polyimide according to claim 1, wherein X′ in formula II is alkylene with 2 to 30 C atoms, cycloalkylene with 5 to 8 ring carbon atoms, aralkylene with 7 to 30 C atoms, arylene with 6 to 27 C atoms or a polysiloxane radical.

18. A polyimide according to claim 17, wherein an arylene radical X′ has the formula IV

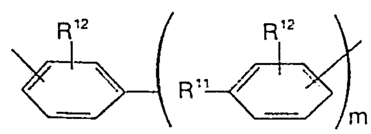 (IV)

in which m is 0 or 1, the free bonds are in the meta-position or, preferably, the ortho-position relative to the $R^{12}$ group, $R^{11}$ is as defined in formula IIIa and $R^{12}$ has the same meaning as $R^5$.

19. A polyimide according to claim 18, wherein X′ has the formula IVa, IVb and/or IVc

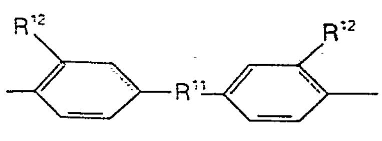 (IVa) , 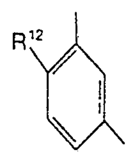 (IVb) , 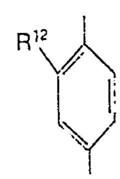 (IVc) ,

in which $R^{11}$ is a direct bond, –O–, –CO– or $-CH_2-$ and $R^{12}$ is methyl, ethyl, isopropyl, methoxy, ethoxy or a hydrogen atom.

20. A polyimide according to claim 1, which contains 20–100 mol %, especially 50–100 mol % of structural elements of the formula I and 80–0 mol %, especially 50–0 mol % of structural elements of the formula II.

21. A polyimide according to claim 1, which consists of recurring structural elements of the formulae

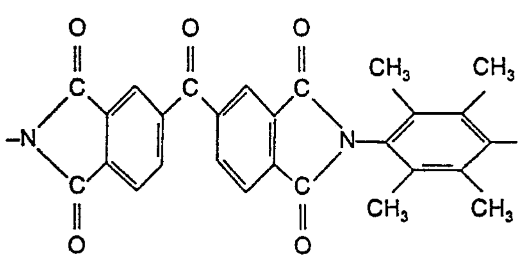

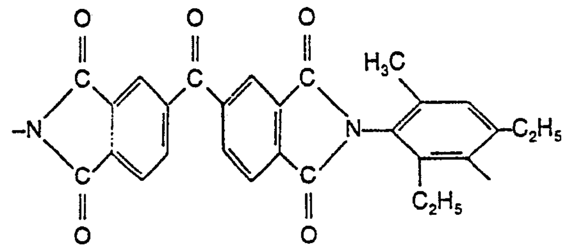

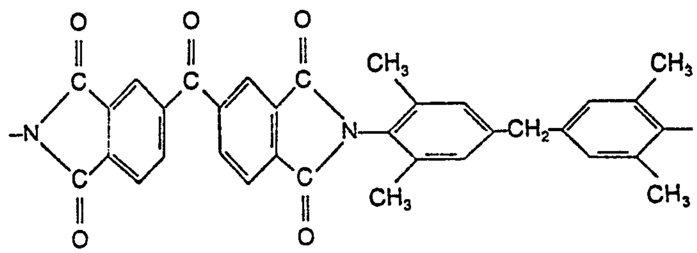

or

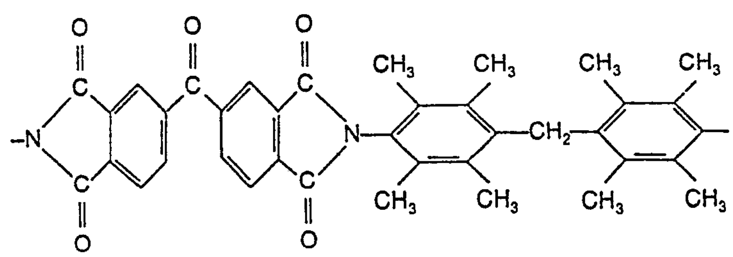

or mixtures of such structural elements.

22. A process for the preparation of polyimides according to claim 1, which comprises subjecting at least one tetracarboxylic acid of the formula V

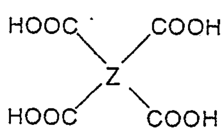

(V)

by itself or together with at least one tetracarboxylic acid of the formula Va, or polyimide-forming derivatives thereof,

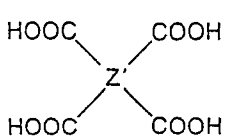

(Va)

to a polycondensation reaction with at least 5 mol %, based on the diamines, of at least one diamine of the formula VI

$$H_2N-X-BH_2 \qquad (VI)$$

by itself or together with at most 95 mol % of at least one diamine of the formula VIa

$$H_2N-X'-NH_2 \qquad (VIa)$$

in which Z, Z', X, and X' are as defined in claim 1, and then cyclising the product, in a manner which is known per se.

23. A coated material consisting of a carrier material onto which a coating of a polyimide according to either of claims 1 and 21 is applied.

24. A process for the preparation of crosslinked polyimides, which comprises irradiating a polyimide according to claim 1 with high-energy radiation.

25. A process for the production of relief structures comprising the imagewise exposure of a coated material according to claim 23 with high-energy radiation through a photomark, subsequent development and, where appropriate, aftertreatment with heat.

26. A process for the production of protective films comprising the direct irradiation of a coated material according to claim 23 with high-energy radiation.

27. The use of a polyimide according to claim 1 for the production of protective films, or photographic relief images.

**Revendications**

1. Homopolyimides et copolyimides qui dérivent d'au moins un acide tétracarboxylique aromatique et d'au moins une diamine aromatique et qui sont constitués de 5 à 100% en moles d'au moins une unité structurale de formule I:

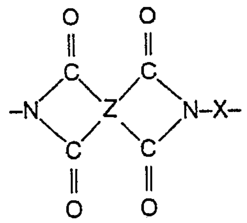

(I)

et de 95 à 0% en moles d'au moins une unité structurale de formule II:

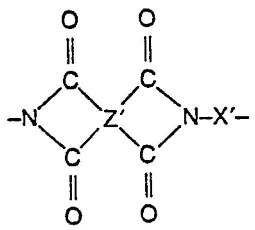

(II),

formules dans lesquelles:

Z représente un radical aromatique quadrivalent, substitué ou non, sur lequel les radicaux carbonyles sont deux couples de radicaux en ortho ou en péri,

X représente le radical bivalent d'une diamine aromatique,

Z′ a la signification de Z ou représente un radical aromatique quadrivalent différent de Z, et

X′ représente le radical bivalent, différent de X, d'une diamine aromatique,

homopolyimides et copolyimides caractérisés en ce que le radical aromatique X porte, en chacune des deux positions ortho par rapport à au moins un atome d'azote, un alkyle, un cycloalkyle, un alcoxy, un alcoxyalkyle ou un aralkyle, ou en ce que deux atomes de carbone voisins appartenant au radical aromatique sont reliés par un alkylène, avec la condition qu'il y ait dans le polyimide, au moins 5% en moles de radicaux d'un acide benzophénone-tétracarboxylique par rapport aux radicaux d'acides tétracarboxyliques.

2. Polyimides selon la revendication 1, caractérisés en ce que X, en tant que radical aromatique, représente un radical phénylène bivalent à un ou à deux noyaux.

3. Polyimides selon la revendication 1, caractérisés en ce que le substituant porté par X contient de 1 à 20 atomes de carbone lorsqu'il est un alkyle ou un alcoxy, de 2 à 12 atomes de carbone lorsqu'il est un alcoxyalkyle, 5 ou 6 atomes de carbone dans le cycle lorsqu'il est un cycloalkyle, et 3 ou 4 atomes de carbone lorsqu'il est un alkylène, et en ce qu'il est, en tant qu'aralkyle, un radical benzyle.

4. Polyimides selon la revendication 3 caractérisés en ce que le substituant est un alkyle contenant de 1 à 4 atomes de carbone, de préférence un isopropyle, un éthyle ou, mieux, un méthyle.

5. Polyimides selon la revendication 1, caractérisés en ce que Z et Z′, en tant que radicaux aromatiques, contiennent chacun de 6 à 30 atomes de carbone.

6. Polyimides selon la revendication 1, caractérisés en ce que Z et Z′ sont pris dans l'ensemble des radicaux suivants:

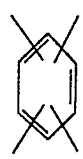 , 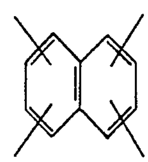 ,

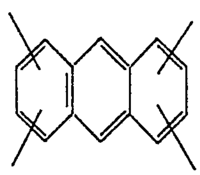 , 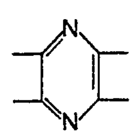 , 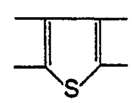

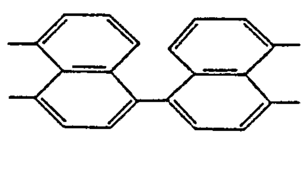 , 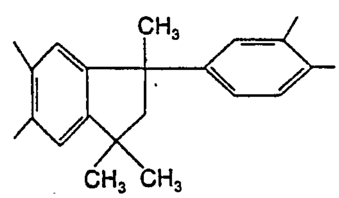

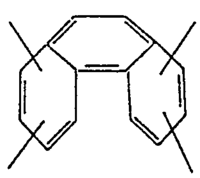 , 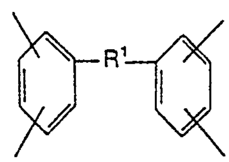

où $R^1$ représente une liaison directe ou un radical formant pont et répondant à l'une des formules suivantes:

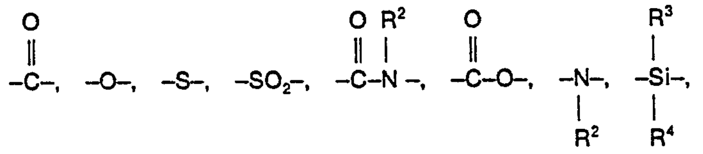

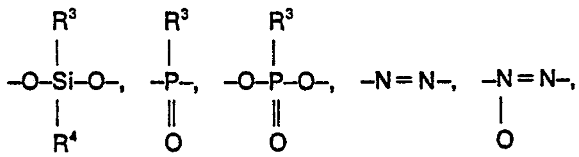

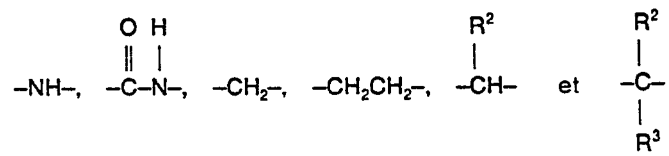

dans lesquelles $R^2$, $R^3$ et $R^4$ représentent chacun un alkyle contenant de 1 à 6 atomes de carbone, un phényle ou un benzyle, et $R^3$ et $R^4$ peuvent aussi représenter chacun un alcoxy contenant de 1 à 6 atomes de carbone, un phénoxy ou un benzyloxy.

7. Polyimides selon la revendication 6, caractérisés en ce que Z et Z' représentent chacun un radical répondant à l'une des formules suivantes:

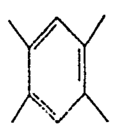 et 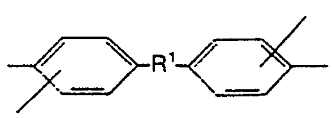

le symbole $R^1$ désignant une liaison directe, $-O-$, $-SO_2-$, $-CH_2-$ ou, plus particulièrement, $-CO-$.

8. Polyimides selon la revendication 7, caractérisés en ce que Z et Z' représentent chacun un radical répondant à l'une des formules:

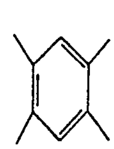 et 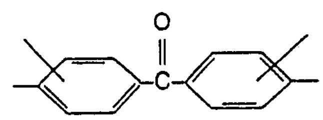

ou des mélanges de ces radicaux.

9. Polyimides selon la revendication 1, caractérisés en ce que X, en tant que radical aromatique, répond à l'une des formules III, IIIa et IIIb:

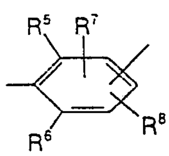 (III) 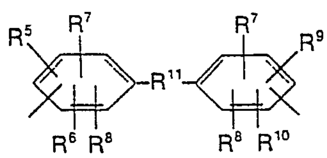 (IIIa) 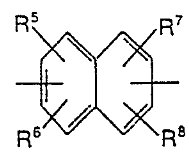 (IIIb)

où, dans la formule III, les liaisons libres sont en position méta ou para l'une par rapport à l'autre, dans la formule IIIa les liaisons libres sont de préférence en position méta ou para relativement au radical $R^{11}$, et $R^5$ et $R^6$ occupent les deux positions ortho par rapport à la liaison libre, et, dans la formule IIIb, les liaisons libres sont en position 2, 3, 6 ou 7, et $R^5$ et $R^6$ se trouvent aux deux positions ortho par rapport aux liaisons libres, $R^{11}$ représente une liaison directe, $-O-$, $-S-$, $-SS-$, $-SO-$, $-SO_2-$, $-CO-$, $-COO-$, $-NH-$, un radical $-N$-alkyl dont l'alkyle contient de 1 à 6 atomes de carbone, $-N$-phényl, $-N$-benzyl, $-CONH-$, un radical $-CON(alkyl)-$ dont l'alkyle contient de 1 à 6 atomes de carbone, $-CON(phényl)-$, $-CON(benzyl)-$, un radical:

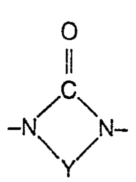 (dans lequel Y représente un radical 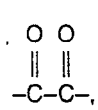, 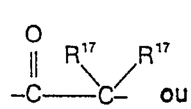 ou 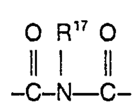

et $R^{17}$ un atome d'hydrogène, un alkyle en $C_1$–$C_6$ ou un phényle), un alkylène linéaire ou ramifié qui contient de 1 à 3 atomes de carbone, un alkylidène en $C_2$–$C_{12}$ éventuellement porteur de Cl ou F, un cycloalkylidène contenant 5 ou 6 atomes de carbone dans son cycle, un phénylène, un phénylènedioxy, ou un radical répondant à l'une des formules:

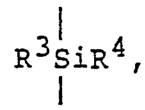, 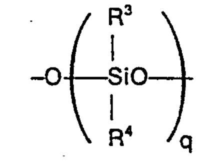 et 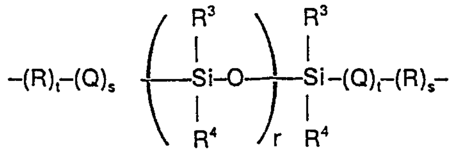

(dans lesquelles $R^3$ et $R^4$ représentent chacun un alkyle ou un alcoxy en $C_1$–$C_6$, un phényle, un benzyle, un phényloxy ou un benzyloxy, r désigne un nombre de 1 à 10, t est égal à 0 ou à 1, s est égal à 0 ou à 1, R représente –O– ou –S–, Q représente un alkylène en $C_1$–$C_6$ et q désigne un nombre de 1 à 100), $R^5$ et $R^6$ représentent chacun un alkyle ou un alcoxy en $C_1$–$C_{12}$, un alcoxyalkyle en $C_2$–$C_{12}$, un cyclopentyle, un cyclohexyle ou un benzyle, ou, dans les formules III et IIIa, $R^5$ et $R^7$ sont voisins l'un de l'autre et forment ensemble un radical triméthylène ou tétraméthylène, le symbole $R^6$ pouvant alors désigner aussi un atome d'hydrogène, $R^7$ et $R^8$ représentent chacun un atome d'hydrogène ou ont chacun, indépendamment l'un de l'autre, la signification de $R^5$ et $R^6$, et $R^9$ et $R^{10}$ représentent chacun un atome d'hydrogène ou ont chacun, indépendamment l'un de l'autre, la signification de $R^5$ et $R^6$, ou encore $R^7$ et $R^9$, dans la formule IIIa, forment ensemble un radical triméthylène ou tétraméthylène.

10. Polyimides selon la revendication 9, caractérisés en ce que $R^5$ et $R^6$ représentent chacun un alkyle contenant de 1 à 6 atomes de carbone, en particulier un méthyle, un éthyle, un n-propyle ou un isopropyle.

11. Polyimides selon la revendication 9, caractérisés en ce que $R^{11}$ représente $-CH_2-$, –O–, –CO– ou une liaison directe.

12. Polyimides selon la revendication 9, caractérisés en ce que, dans la formule IIIa, les liaisons libres sont en position para relativement au radical $R^{11}$.

13. Polyimides selon la revendication 1, caractérisés en ce qu'ils contiennent au moins 2 unités structurales différentes, de préférence de 2 à 4.

14. Polyimides selon la revendication 13, caractérisés en ce que les unités structurales de formule I diffèrent par le radical X.

15. Polyimides selon la revendication 9, caractérisés en ce que X, dans la formule I, représente un radical répondant à l'une des formules suivantes:

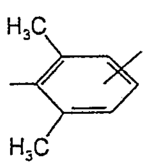, 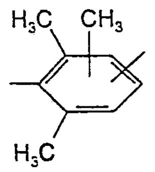, 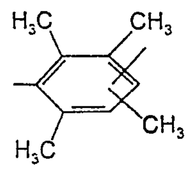 et 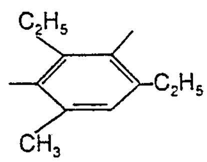

(dans lesquelles les liaisons libres sont en position méta ou para l'une par rapport à l'autre), ou à la formule suivante:

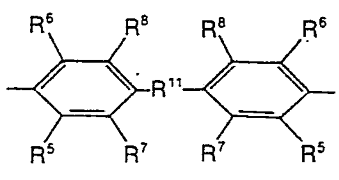

dans laquelle $R^5$ et $R^6$ représentent chacun, indépendamment l'un de l'autre, un radical méthyle, éthyle, n-propyle ou isopropyle et $R^7$ et $R^8$ représentent chacun un atome d'hydrogène ou ont chacun la signification de $R^5$, ou $R^5$ et $R^7$ forment ensemble un radical triméthylène ou tétraméthylène et $R^6$ et $R^8$ représentent chacun un atome d'hydrogène, et $R^{11}$ représente une liaison directe ou un radical $-CH_2-$ ou –CO–.

16. Polyimides selon la revendication 15, caractérisés en ce qu'ils sont des copolyimides renfermant deux ou plus de deux radicaux répondant à l'une des formules suivantes:

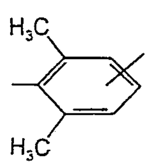, 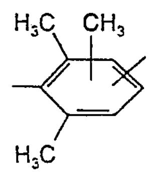, 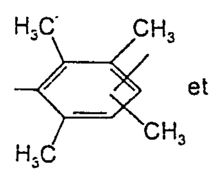 et 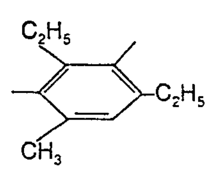

(dans lesquelles les liaisons libres sont en position méta ou para l'une par rapport à l'autre), ou à la formule suivante:

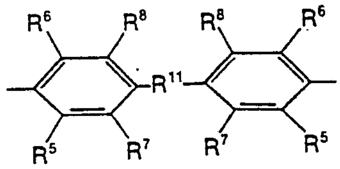

dans laquelle $R^5$, $R^6$, $R^7$, $R^8$ et $R^{11}$ ont les significations qui leur ont été données à la revendication 15.

17. Polyimides selon la revendication 1, caractérisés en ce que X', dans la formule II, représente un alkylène contenant de 2 à 30 atomes de carbone, un cycloalkylène contenant de 5 à 8 atomes de carbone dans son cycle, un aralkylène contenant de 7 à 30 atomes de carbone, un arylène contenant de 6 à 22 atomes de carbone ou un radical de polysiloxane.

18. Polyimides selon la revendication 17, caractérisés en ce que X', en tant que radical arylène, répond à la formule IV:

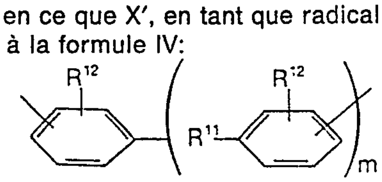 (IV)

dans laquelle m est égal à 0 ou à 1, les liaisons libres se trouvent de préférence en position méta ou, mieux, en position ortho par rapport au radical $R^{12}$, $R^{11}$ a la même signification que dans la formule IIIa, et $R^{12}$ a la même signification que $R^5$.

19. Polyimides selon la revendication 18, caractérisés en ce que X' représente un radical répondant à l'une des formules IVa, IVb et IVc:

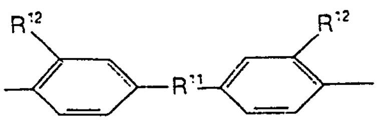 (IVa) , 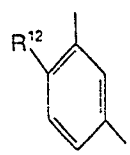 (IVb) , 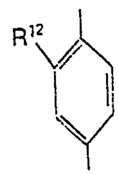 (IVc) .

dans lesquelles $R^{11}$ représente une liaison directe, $-O-$, $-CO-$ ou $-CH_2-$, et $R^{12}$ représente un radical méthyle, éthyle, isopropyle, méthoxy ou éthoxy ou un atome d'hydrogène.

20. Polyimides selon la revendication 1, caractérisés en ce qu'ils contiennent de 20 à 100% en moles d'unités structurales de formule I, plus particulièrement de 50 à 100% en moles, et de 80 à 0% en moles d'unités structurales de formule II, plus particulièrement de 50 à 0% en moles.

21. Polyimides selon la revendication 1, caractérisés en ce qu'ils sont constitués d'unités structurales répétées de formules:

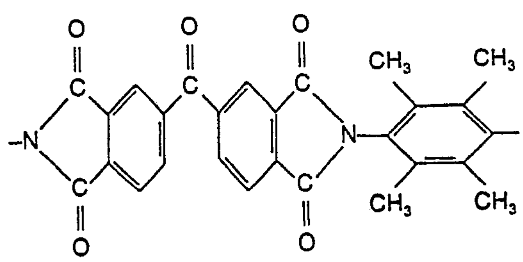

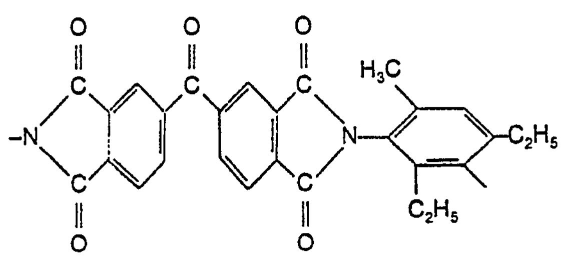

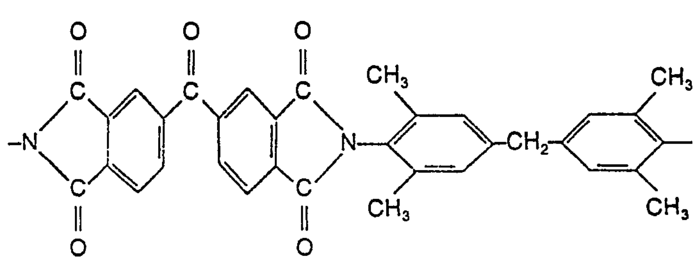

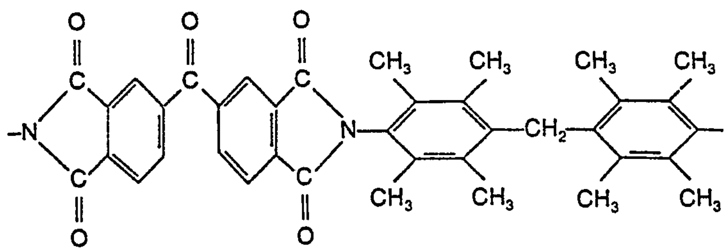

ou de mélanges de telles unités structurales.

22. Procédé de préparation de polyimides selon la revendication 1, procédé caractérisé en ce que, en opérant de manière connue, on polycondense un acide tétracarboxylique de formule V:

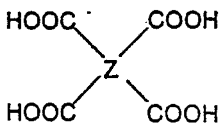

(V)

seul ou associé à au moins un acide tétracarboxylique de formule Va:

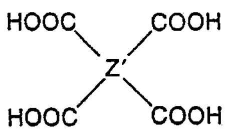

(Va)

ou des dérivés de ces acides capables d'engendrer des polyimides, avec au moins 5% en moles, par rapport aux diamines, d'au moins une diamine de formule VI:

$$H_2N\text{–}X\text{–}NH_2 \qquad (VI),$$

seule ou associée à au plus 95% en moles d'au moins une diamine de formule VIa:

$$H_2N\text{–}X'\text{–}NH_2 \qquad (VIa),$$

formules dans lesquelles Z, Z', X et X' ont les significations qui leur ont été données à la revendication 1, et ensuite on cyclise.

23. Matière revêtue constituée d'une matière support sur laquelle est déposée une couche d'un polyimide selon l'une des revendications 1 ou 21.

24. Procédé de préparation de polyimides réticulés, procédé caractérisé en ce qu'on expose à un rayonnement de haute énergie un polyimide selon la revendication 1.

25. Procédé de fabrication de structures en relief selon lequel on irradie conformément à une image, à travers un photomasque, au moyen d'un rayonnement de haute énergie, une matière revêtue selon la revendication 23, ensuite on développe et, éventuellement, on effectue un traitement complémentaire par la chaleur.

26. Procédé de fabrication de pellicules protectrices selon lequel on expose directement à un rayonnement de haute énergie une matière revêtue selon la revendication 23.

27. Application de polyimides selon la revendication 1 à la fabrication de pellicules protectrices ou d'images photographiques en relief.